# EUROPÄISCHE PATENTSCHRIFT

(11) **EP 4 193 573 B1**
(45) Veröffentlichungstag und Bekanntmachung des Hinweises auf die Patenterteilung: **20.03.2024**
(21) Anmeldenummer: 21745770.4
(22) Anmeldetag: 15.07.2021
(51) Int. Cl.: H04L 12/40, H04J 3/06

(54) **TEILNEHMERSTATION FÜR EIN SERIELLES BUSSYSTEM UND VERFAHREN ZUR KOMMUNIKATION IN EINEM SERIELLEN BUSSYSTEM**
SUBSCRIBER STATION FOR A SERIAL BUS SYSTEM, AND METHOD FOR COMMUNICATION IN A SERIAL BUS SYSTEM
STATION D'ABONNÉ D'UN SYSTÈME DE BUS SÉRIE ET PROCÉDÉ DE COMMUNICATION DANS UN SYSTÈME DE BUS SÉRIE

(30) Priorität: 05.08.2020 DE 102020209917
(43) Veröffentlichungstag der Anmeldung: 14.06.2023
(73) Patentinhaber: Robert Bosch GmbH, 70442 Stuttgart (DE)
(72) Erfinder: HARTWICH, Florian, 72762 Reutlingen (DE); HORST, Christian, 72144 Dusslingen (DE); BAILER, Franz, 72116 Moessingen (DE); MUTTER, Arthur, 73765 Neuhausen (DE)
(86) Internationale Anmeldenummer: PCT/EP2021/069742
(87) Internationale Veröffentlichungsnummer: WO 2022/028843

(56) Entgegenhaltungen:
- DE-A1-102011 122 845
- DE-A1-102018 221 958

## Beschreibung

### Technisches Gebiet

Die vorliegende Erfindung betrifft eine Teilnehmerstation für ein serielles Bussystem und ein Verfahren zur Kommunikation in einem seriellen Bussystem, das mit hoher Datenrate sowie großer Flexibilität und großer Fehlerrobustheit arbeitet.

### Stand der Technik

Bussysteme für die Kommunikation zwischen Sensoren und Steuergeräten, beispielsweise in Fahrzeugen, sollen je nach der Anzahl an Funktionen einer technischen Anlage bzw. eines Fahrzeugs, die Übertragung einer großen Datenmenge ermöglichen. Dabei wird oft gefordert, dass die Daten schneller vom Sender zum Empfänger zu übertragen sind als bisher und bei Bedarf auch große Datenpakete übertragbar sind.

Bei Fahrzeugen ist derzeit ein Bussystem in der Einführungsphase, in welchem Daten als Nachrichten im Standard ISO11898-1:2015 als CAN Protokoll-Spezifikation mit CAN FD übertragen werden. Die Nachrichten werden zwischen den Busteilnehmern des Bussystems, wie Sensor, Steuergerät, Geber, usw., übertragen. Hierfür wird die Nachricht auf den Bus in einem Rahmen gesendet, in dem zwischen zwei Kommunikationsphasen umgeschaltet wird. In der ersten Kommunikationsphase (Arbitration) wird ausgehandelt, welche der Teilnehmerstationen des Bussystems in der nachfolgenden zweiten Kommunikationsphase (Datenphase bzw. Senden der Nutzdaten) ihren Rahmen auf den Bus senden darf. CAN FD wird von den meisten Herstellern im ersten Schritt mit 500kbit/s Arbitrationsbitrate und 2Mbit/s Datenbitrate im Fahrzeug eingesetzt. Es ist also bei der Übertragung auf dem Bus zwischen einer langsamen Betriebsart und einer schnellen Betriebsart hin und her zu schalten.

Um noch größere Datenraten in der zweiten Kommunikationsphase zu ermöglichen, wird derzeit ein Nachfolgebussystem für CAN FD entwickelt, das CAN XL genannt wird und derzeit bei der Organisation CAN in Automation (CiA) standardisiert wird. CAN XL soll neben dem reinen Datentransport über den CAN-Bus auch andere Funktionen unterstützen, wie funktionale Sicherheit (Safety), Datensicherheit (Security) und Dienstgüte (QoS = Quality of Service). Dies sind elementare Eigenschaften, die in einem autonom fahrenden Fahrzeug benötigt werden.

Bei der Übertragung von Daten in einem Rahmen über einen Kanal (CAN Bus) kann es zu Fehlern kommen. Insbesondere kann durch äußere Einflüsse, insbesondere Einstrahlung, ein Bit verfälscht werden. Das Kommunikationsprotokoll von CAN XL muss Fehler erkennen und darauf reagieren.

Bei CAN XL kann der Fehler entweder mit oder ohne Fehler-Signalisierung behandelt werden. Zur Fehler-Signalisierung sendet eine Teilnehmerstation, die einen Fehler detektiert, einen Fehlerrahmen (Error Flag) auf den Bus, um den anderen Teilnehmerstationen mitzuteilen, dass ein Fehler erkannt wurde. Ohne Fehler-Signalisierung sendet eine Teilnehmerstation, die einen Fehler detektiert, keinen Fehlerrahmen (Error Flag) auf den Bus. Somit bekommt die sendende Teilnehmerstation (Sendeknoten) keine Rückmeldung von der nur empfangenden Teilnehmerstation (Empfangsknoten), die den Rahmen nicht korrekt empfangen konnte. Diese Art der Kommunikation nennt man auch "Fire and forget", was auch als Senden und Vergessen bezeichnet werden kann.

Wird kein Fehlerrahmen auf den Bus gesendet, sendet die sendende Teilnehmerstation (Sendeknoten) den kompletten Rahmen auf den Bus, da die Rückmeldung über den Fehler ausbleibt. Empfangende Teilnehmerstationen (Empfangsknoten), die den Rahmen nicht korrekt empfangen konnten, schalten ihre Sende-/Empfangseinrichtung (Transceiver) von der schnellen Betriebsart (FAST) in die langsame Betriebsart (SLOW) zurück, falls die Sende-/Empfangseinrichtung nicht vorher schon in der langsamen Betriebsart war, und versuchen danach, sich in die laufende Kommunikation auf dem Bus zu reintegrieren. Infolgedessen warten diese Teilnehmerstationen auf eine Sequenz aus 11 rezessiven Bits in Folge, die sogenannte Bus-Idle-Sequenz, die nur am Ende eines Rahmens auftreten kann. Auf diese Sequenz warten auch Teilnehmerstationen, die neu eingeschaltet werden oder nach einer Inaktivschaltung wieder aktiv geschaltet werden und in der Folge an der Kommunikation im Bus teilnehmen wollen.

Wichtig ist dabei, dass alle sich in die Kommunikation integrierenden Teilnehmerstationen die Erkennung der 11 rezessiven Bits am Ende eines Rahmens quasi gleichzeitig abschließen. Diese Synchronizität ist notwendig, weil alle Teilnehmerstationen im darauffolgenden Bit, also dem Bit, das auf die 11 rezessiven Bits folgt, gleichzeitig bereit sein müssen zum Senden oder zum Empfangen eines Rahmens.

Damit diese Synchronizität der Teilnehmerstationen erreicht wird, ist in einem DAS-Feld in dem CAN XL Rahmen eine Synchronisationsflanke vorhanden, auf die sich alle Empfangsknoten synchronisieren sollen. Danach kann die Re-Integration synchron erfolgen.

Problematisch ist jedoch, wenn alle Empfangsknoten einen Fehler während der Datenphase gesehen haben. In diesem Fall sendet keiner der Empfangsknoten ein dominantes ACK-Bit als Bestätigung für einen korrekten Empfang des Rahmens. Dadurch ist die Synchronisationsflanke im DAS-Feld die letzte mögliche Flanke für eine Synchronisation vor der Bus-Idle-Sequenz. Dabei hat sich gezeigt, dass mit dem DAS-Feld im aktuellen CAN XL Rahmenformat eine korrekte Synchronisierung nicht unter allen Umständen möglich ist.

Die DE 10 2018 221 958 A1 offenbart eine Teilnehmerstation für ein serielles Bussystem und ein Verfahren zur Kommunikation in einem seriellen Bussystem. Die Teilnehmerstation hat eine Kommunikationssteuereinrichtung zum Steuern einer Kommunikation der Teilnehmerstation mit mindestens einer anderen Teilnehmerstation des Bussystems, wobei die Kommunikationssteuereinrichtung ausgestaltet ist, das Sendesignal gemäß einem Rahmen zu erzeugen, in dem ein Feld für eine Kopfprüfsumme und ein Feld für eine Rahmenprüfsumme vorgesehen ist.

### Offenbarung der Erfindung

Daher ist es Aufgabe der vorliegenden Erfindung, eine Teilnehmerstation für ein serielles Bussystem und ein Verfahren zur Kommunikation in einem seriellen Bussystem bereitzustellen, welche die zuvor genannten Probleme lösen. Insbesondere sollen eine Teilnehmerstation für ein serielles Bussystem und ein Verfahren zur Kommunikation in einem seriellen Bussystem bereitgestellt werden, bei welchen die Re-Integration eines Empfangsknotens nach einem Fehler oder nach dem Einschalten bei laufender Bus-Kommunikation immer korrekt erfolgen kann, um auch bei hoher Datenrate und einer Steigerung der Menge der Nutzdaten pro Rahmen eine große Fehlerrobustheit der Kommunikation zu realisieren.

Die Aufgabe wird durch eine Teilnehmerstation für ein serielles Bussystem mit den Merkmalen von Anspruch 1 gelöst. Die Teilnehmerstation hat eine Kommunikationssteuereinrichtung zum Steuern einer Kommunikation der Teilnehmerstation mit mindestens einer anderen Teilnehmerstation des Bussystems, so dass sich für eine Nachricht, die zwischen Teilnehmerstationen des Bussystems ausgetauscht wird, die Bitzeit eines in der ersten Kommunikationsphase auf den Bus gesendeten Signals unterscheiden kann von einer Bitzeit eines in der zweiten Kommunikationsphase gesendeten Signals, und eine Sende-/Empfangseinrichtung zum Senden des Sendesignals auf einen Bus des Bussystems, wobei die Kommunikationssteuereinrichtung ausgestaltet ist, das Sendesignal gemäß einem Rahmen zu erzeugen und in den Rahmen nach der zweiten Kommunikationsphase ein Feld mit einer Flanke einzufügen, wobei das Feld vor der Flanke eine vorbestimmte Länge entsprechend einer Zeitdauer hat, die länger als die Zeitdauer einer Bitzeit der ersten Kommunikationsphase ist, und wobei die Flanke zur Synchronisation auf die Kommunikation auf dem Bus für eine Kommunikationssteuereinrichtung der mindestens einen anderen Teilnehmerstation des Bussystems vorgesehen ist, deren Sende-/Empfangseinrichtung vor der vorbestimmten Zeitdauer in eine Betriebsart zum Senden und Empfangen des Rahmens in der ersten Kommunikationsphase geschaltet ist.

Durch die Ausgestaltung der Teilnehmerstation ist ein verändertes DAS-Feld vorhanden, mit dem sichergestellt ist, dass sich alle in die Kommunikation am Bus re-integrierenden Teilnehmerstationen in dem DAS-Feld synchronisieren können. Dies ermöglicht eine sichere Fehlerbehandlung selbst bei Fehlern aufgrund von Einstrahlung. Außerdem ist die Fairness sichergestellt, weil alle Teilnehmerstationen (Knoten) zeitgleich wieder sendebereit bzw. empfangsbereit sind. Zudem können dadurch Folgefehler bei der Kommunikation in dem Bussystem vermieden werden.

Mit der Teilnehmerstation wird damit eine robuste Kommunikation mit CAN XL erst ermöglicht.

Somit ist es mit der Teilnehmerstation in dem Bussystem möglich, in einer ersten Kommunikationsphase eine von CAN bekannte Arbitration beizubehalten und dennoch die Übertragungsrate gegenüber CAN oder CAN FD nochmals beträchtlich zu steigern.

Das von der Teilnehmerstation durchgeführte Verfahren kann auch zum Einsatz kommen, wenn in dem Bussystem auch mindestens eine CAN-Teilnehmerstation und/oder mindestens eine CAN FD Teilnehmerstation vorhanden ist, die Nachrichten nach dem CAN-Protokoll und/oder CAN FD Protokoll senden.

Vorteilhafte weitere Ausgestaltungen der Teilnehmerstation sind in den abhängigen Ansprüchen angegeben.

Möglich ist, dass die vorbestimmte Länge des Felds mindestens drei Bits mit der Bitzeit der ersten Kommunikationsphase aufweist.

Die Flanke kann eine fallende Flanke sein.

Die Kommunikationssteuereinrichtung kann ausgestaltet sein, in dem Feld vor der Flanke die Bitfolge mit dem logischen Wert 11 einzufügen.

Die Kommunikationssteuereinrichtung kann ausgestaltet sein, das Feld als eine Bitfolge mit dem logischen Wert 1101 einzufügen.

Gemäß einem Ausführungsbeispiel ist die Kommunikationssteuereinrichtung ausgestaltet, der Sende-/Empfangseinrichtung mittels Pulsweitenmodulation in dem Sendesignal zu signalisieren, dass die Sende-/Empfangseinrichtung ihre Betriebsart umzuschalten hat.

Denkbar ist, dass die Teilnehmerstation zudem die Sende-/Empfangseinrichtung zum Senden des Sendesignals auf einen Bus des Bussystems aufweist, wobei die Sende-/Empfangseinrichtung ausgestaltet ist, nach Ablauf einer vorbestimmten Zeitdauer, in der die Sende-/Empfangseinrichtung in dem Sendesignal keine Flanken empfangen hat, ihre Betriebsart von der Betriebsart der zweiten Kommunikationsphase in die unterschiedliche Betriebsart der ersten Kommunikationsphase umzuschalten.

Gemäß einem Ausführungsbeispiel ist die Kommunikationssteuereinrichtung ausgestaltet, als letztes Symbol in dem Sendesignal vor dem Beginn der vorbestimmten Zeitdauer ein PWM-Symbol mit dem logischen Wert 0 einzufügen.

Gemäß einem Ausführungsbeispiel ist die Kommunikationssteuereinrichtung ausgestaltet, als letztes Symbol in dem Sendesignal vor dem Beginn der vorbestimmten Zeitdauer ein PWM-Symbol mit dem logischen Wert 1 einzufügen.

Gemäß einem Ausführungsbeispiel ist die Kommunikationssteuereinrichtung ausgestaltet, als vorletztes Symbol in dem Sendesignal vor dem Beginn der vorbestimmten Zeitdauer ein PWM-Symbol mit dem logischen Wert 0 einzufügen, und als letztes Symbol in dem Sendesignal vor dem Beginn der vorbestimmten Zeitdauer ein PWM-Symbol in das Sendesignal einzufügen, das den logischen Wert 0 hat, jedoch keine abschließende Flanke hat.

Die Kommunikationssteuereinrichtung kann ausgestaltet sein, das Signal an einem Anschluss, an welchem die Sende-/Empfangseinrichtung ein Empfangssignal an die Kommunikationssteuereinrichtung sendet, in Bezug darauf zu prüfen, ob die Sende-/Empfangseinrichtung ihre Betriebsart von der Betriebsart der zweiten Kommunikationsphase in die unterschiedliche Betriebsart der ersten Kommunikationsphase umgeschaltet hat.

Gemäß einem anderen Ausführungsbeispiel ist die Sende-/Empfangseinrichtung ausgestaltet ist, den gesamten Rahmen in der Betriebsart zum Senden und Empfangen des Rahmens in der ersten Kommunikationsphase auf den Bus zu senden.

Möglich ist, dass der für die Nachricht gebildete Rahmen kompatibel zu CAN FD aufgebaut ist, wobei in der ersten Kommunikationsphase ausgehandelt wird, welche der Teilnehmerstationen des Bussystems in der nachfolgenden zweiten Kommunikationsphase einen zumindest zeitweise exklusiven, kollisionsfreien Zugriff auf den Bus bekommt.

Die zuvor beschriebene Teilnehmerstation kann Teil eines Bussystems sein, das zudem einen Bus und mindestens zwei Teilnehmerstationen umfasst, welche über den Bus derart miteinander verbunden sind, dass sie seriell miteinander kommunizieren können. Hierbei ist mindestens eine der mindestens zwei Teilnehmerstationen eine zuvor beschriebene Teilnehmerstation.

Die zuvor genannte Aufgabe wird zudem durch ein Verfahren zur Kommunikation in einem seriellen Bussystem nach Anspruch 15 gelöst. Das Verfahren wird mit einer Teilnehmerstation des Bussystems ausgeführt, die eine Kommunikationssteuereinrichtung und eine Sende-/Empfangseinrichtung aufweist, wobei das Verfahren die Schritte aufweist, Steuern, mit der Kommunikationssteuereinrichtung einer Kommunikation der Teilnehmerstation mit mindestens einer anderen Teilnehmerstation des Bussystems, so dass sich für eine Nachricht, die zwischen Teilnehmerstationen des Bussystems ausgetauscht wird, die Bitzeit eines in der ersten Kommunikationsphase auf den Bus gesendeten Signals unterscheiden kann von einer Bitzeit eines in der zweiten Kommunikationsphase gesendeten Signals, und Senden, mit der Sende-/Empfangseinrichtung, des Sendesignals auf einen Bus des Bussystems, wobei die Kommunikationssteuereinrichtung das Sendesignal gemäß einem Rahmen erzeugt und in den Rahmen nach der zweiten Kommunikationsphase ein Feld mit einer Flanke einfügt, und wobei das Feld vor der Flanke eine vorbestimmte Länge entsprechend einer Zeitdauer hat, die länger als die Zeitdauer einer Bitzeit der ersten Kommunikationsphase ist, wobei die Flanke zur Synchronisation auf die Kommunikation auf dem Bus für eine Kommunikationssteuereinrichtung der mindestens einen anderen Teilnehmerstation des Bussystems vorgesehen ist, deren Sende-/Empfangseinrichtung vor der vorbestimmten Zeitdauer in eine Betriebsart zum Senden und Empfangen des Rahmens in der ersten Kommunikationsphase geschaltet ist.

Das Verfahren bietet dieselben Vorteile, wie sie zuvor in Bezug auf die Teilnehmerstation genannt sind.

Weitere mögliche Implementierungen der Erfindung umfassen auch nicht explizit genannte Kombinationen von zuvor oder im Folgenden bezüglich der Ausführungsbeispiele beschriebenen Merkmale oder Ausführungsformen. Dabei wird der Fachmann auch Einzelaspekte als Verbesserungen oder Ergänzungen zu der jeweiligen Grundform der Erfindung hinzufügen.

### Zeichnungen

Nachfolgend ist die Erfindung unter Bezugnahme auf die beiliegende Zeichnung und anhand von Ausführungsbeispielen näher beschrieben. Es zeigen:
Fig. 1 ein vereinfachtes Blockschaltbild eines Bussystems gemäß einem ersten Ausführungsbeispiel;
Fig. 2 ein Schaubild zur Veranschaulichung des Aufbaus einer Nachricht, die von einer Teilnehmerstation des Bussystems gemäß dem ersten Ausführungsbeispiel gesendet werden kann;
Fig. 3 ein vereinfachtes schematisches Blockschaltbild einer Teilnehmerstation des Bussystems gemäß dem ersten Ausführungsbeispiel;
Fig. 4 einen zeitlichen Verlauf von Bussignalen CAN-XL_H und CAN-XL_L bei der Teilnehmerstation gemäß dem ersten Ausführungsbeispiel;
Fig. 5 einen zeitlichen Verlauf einer Differenzspannung VDIFF der Bussignale CAN-XL_H und CAN-XL_L bei der Teilnehmerstation gemäß dem ersten Ausführungsbeispiel;
Fig. 6 bis Fig. 8 jeweils einen zeitlichen Verlauf eines Signals, das beim Senden eines Rahmens an Anschlüssen der Teilnehmerstation gemäß dem ersten Ausführungsbeispiel auftritt, wenn die Teilnehmerstation Sender der Nachricht ist;
Fig. 9 den zeitlichen Verlauf der Differenzspannung VDIFF der Bussignale CAN-XL_H und CAN-XL_L, der aus den Signalen von Fig. 6 bis Fig. 8 resultiert;
Fig. 10 den zeitlichen Verlauf von Zuständen an dem Empfangsanschluss eines Empfangsknotens, die aus der Differenzspannung VDIFF von Fig. 9 resultieren;
Fig. 11 bis Fig. 13 jeweils einen zeitlichen Verlauf eines Signals, das beim Senden eines Rahmens an Anschlüssen der Teilnehmerstation gemäß einem zweiten Ausführungsbeispiel auftritt, wenn die Teilnehmerstation Sender der Nachricht ist;
Fig. 14 den zeitlichen Verlauf der Differenzspannung VDIFF der Bussignale CAN-XL_H und CAN-XL_L, der aus den Signalen von Fig. 11 bis Fig. 13 resultiert;
Fig. 15 den zeitlichen Verlauf von Zuständen an dem Empfangsanschluss eines Empfangsknotens, die aus der Differenzspannung VDIFF von Fig. 14 resultieren;
Fig. 16 bis Fig. 18 jeweils einen zeitlichen Verlauf eines Signals, das beim Senden eines Rahmens an Anschlüssen der Teilnehmerstation gemäß einem dritten Ausführungsbeispiel auftritt, wenn die Teilnehmerstation Sender der Nachricht ist;
Fig. 19 den zeitlichen Verlauf der Differenzspannung VDIFF der Bussignale CAN-XL_H und CAN-XL_L, der aus den Signalen von Fig. 16 bis Fig. 18 resultiert; und
Fig. 20 den zeitlichen Verlauf von Zuständen an dem Empfangsanschluss eines Empfangsknotens, die aus der Differenzspannung VDIFF von Fig. 19 resultieren.

In den Figuren sind gleiche oder funktionsgleiche Elemente, sofern nichts anderes angegeben ist, mit denselben Bezugszeichen versehen.

### Beschreibung der Ausführungsbeispiele

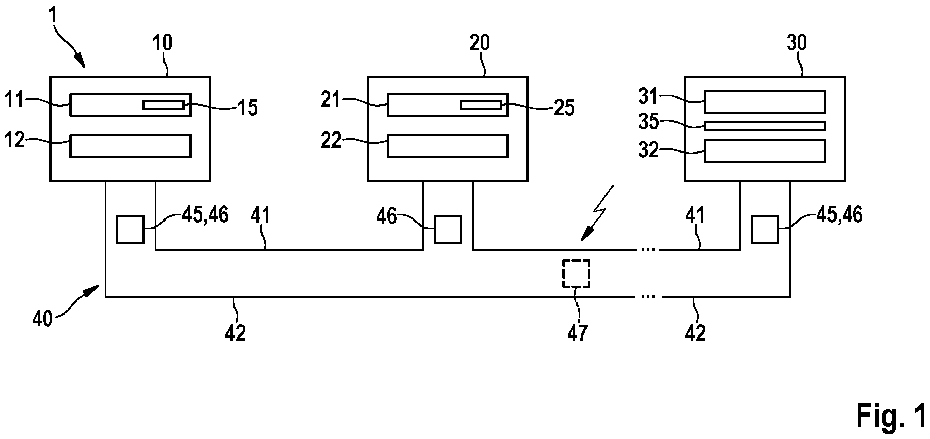

Fig. 1 zeigt als Beispiel ein Bussystem 1, das insbesondere grundlegend für ein CAN-Bussystem, ein CAN FD-Bussystem, ein CAN XL-Bussystem, und/oder Abwandlungen davon ausgestaltet ist, wie nachfolgend beschrieben. Das Bussystem 1 kann in einem Fahrzeug, insbesondere einem Kraftfahrzeug, einem Flugzeug, usw., oder im Krankenhaus usw. Verwendung finden.

In Fig. 1 hat das Bussystem 1 eine Vielzahl von Teilnehmerstationen 10, 20, 30, die jeweils an einen Bus 40 mit einer ersten Busader 41 und einer zweiten Busader 42 angeschlossen sind. Die Busadern 41, 42 können auch CAN_H und CAN_L oder CAN-XL_H und CAN-XL_L genannt werden und dienen zur elektrischen Signalübertragung nach Einkopplung der dominanten Pegel bzw. Erzeugung von rezessiven Pegeln oder anderen Pegeln für ein Signal im Sendezustand. Über den Bus 40 sind Nachrichten 45, 46 in der Form von Signalen zwischen den einzelnen Teilnehmerstationen 10, 20, 30 seriell übertragbar. Tritt bei der Kommunikation auf dem Bus 40 ein Fehler auf, wie durch den gezackten schwarzen Blockpfeil in Fig. 1 dargestellt, kann optional ein Fehlerrahmen 47 (Error Flag) gesendet werden. Die Teilnehmerstationen 10, 20, 30 sind beispielsweise Steuergeräte, Sensoren, Anzeigevorrichtungen, usw. eines Kraftfahrzeugs.

Wie in Fig. 1 gezeigt, hat die Teilnehmerstation 10 eine Kommunikationssteuereinrichtung 11, eine Sende-/Empfangseinrichtung 12 und ein Fehlerbehandlungsmodul 15. Die Teilnehmerstation 20 hat eine Kommunikationssteuereinrichtung 21, eine Sende-/Empfangseinrichtung 22 und optional ein Fehlerbehandlungsmodul 25. Die Teilnehmerstation 30 hat eine Kommunikationssteuereinrichtung 31, eine Sende-/Empfangseinrichtung 32 und ein Fehlerbehandlungsmodul 35. Die Sende-/Empfangseinrichtungen 12, 22, 32 der Teilnehmerstationen 10, 20, 30 sind jeweils direkt an den Bus 40 angeschlossen, auch wenn dies in Fig. 1 nicht veranschaulicht ist.

Die Kommunikationssteuereinrichtungen 11, 21, 31 dienen jeweils zur Steuerung einer Kommunikation der jeweiligen Teilnehmerstation 10, 20, 30 über den Bus 40 mit mindestens einer anderen Teilnehmerstation der Teilnehmerstationen 10, 20, 30, die an den Bus 40 angeschlossen sind.

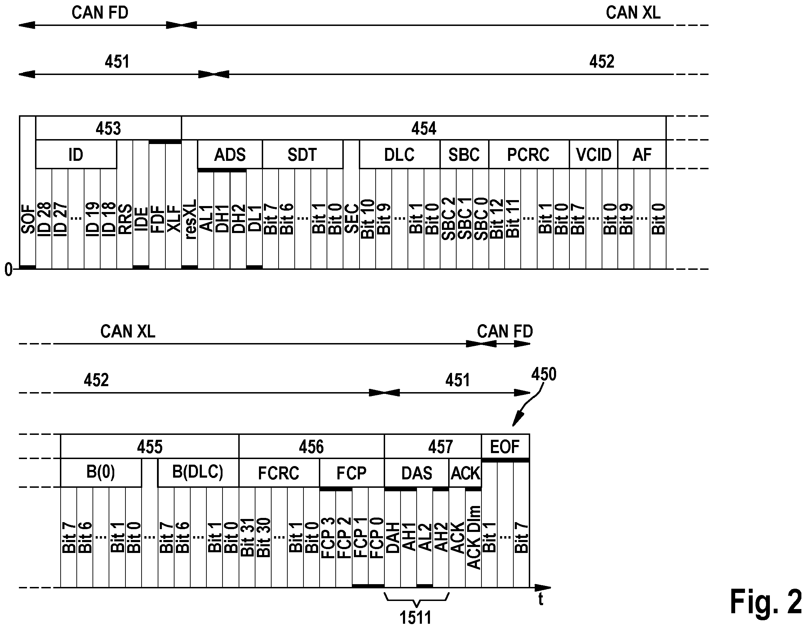

Die Kommunikationssteuereinrichtungen 11, 31 erstellen und lesen erste Nachrichten 45, die beispielsweise modifizierte CAN Nachrichten 45 sind. Hierbei sind die modifizierten CAN Nachrichten 45 auf der Grundlage eines CAN XL-Formats aufgebaut, das in Bezug auf Fig. 2 detaillierter beschrieben ist, und bei welchem das jeweilige Fehlerbehandlungsmodul 15, 35 zum Einsatz kommt. Die Kommunikationssteuereinrichtungen 11, 31 können zudem ausgeführt sein, um je nach Bedarf eine CAN XL-Nachricht 45 oder eine CAN FD-Nachricht 46 für die Sende-/Empfangseinrichtung 32 bereitzustellen oder von dieser zu empfangen. Auch hierbei kommen die jeweiligen Fehlerbehandlungsmodule 15, 35 zum Einsatz. Die Kommunikationssteuereinrichtungen 11, 31 erstellen und lesen also eine erste Nachricht 45 oder zweite Nachricht 46, wobei sich die erste und zweite Nachricht 45, 46 durch ihren Datenübertragungsstandard unterscheiden, nämlich in diesem Fall CAN XL oder CAN FD.

Die Kommunikationssteuereinrichtung 21 kann wie ein herkömmlicher CAN-Controller nach ISO 11898-1:2015 ausgeführt sein, d.h. wie ein CAN FD toleranter Classical CAN-Controller oder ein CAN FD Controller. Zusätzlich ist optional das Fehlerbehandlungsmodul 25 vorhanden, das dieselbe Funktion hat, wie die Fehlerbehandlungsmodule 15, 35. Die Kommunikationssteuereinrichtung 21 erstellt und liest zweite Nachrichten 46, beispielsweise CAN FD-Nachrichten 46. Bei den CAN FD-Nachrichten 46 kann eine Anzahl von 0 bis zu 64 Datenbytes umfasst sein, die noch dazu mit einer deutlich schnelleren Datenrate als bei einer Classical CAN-Nachrichtübertragen werden. Insbesondere ist die Kommunikationssteuereinrichtung 21 wie ein herkömmlicher CAN FD-Controller ausgeführt.

Die Sende-/Empfangseinrichtung 22 kann wie ein herkömmlicher CAN Transceiver nach ISO 11898-1:2015 oder CAN FD Transceiver ausgeführt sein. Die Sende-/Empfangseinrichtungen 12, 32 können ausgeführt sein, um je nach Bedarf Nachrichten 45 gemäß dem CAN XL-Format oder Nachrichten 46 gemäß dem derzeitigen CAN FD-Format für die zugehörige Kommunikationssteuereinrichtung 11, 31 bereitzustellen oder von dieser zu empfangen.

Mit den beiden Teilnehmerstationen 10, 30 ist eine Bildung und dann Übertragung von Nachrichten 45 mit dem CAN XL Format sowie der Empfang solcher Nachrichten 45 realisierbar.

Fig. 2 zeigt für die Nachricht 45 einen CAN XL Rahmen 450, wie er von der Kommunikationssteuereinrichtung 11 für die Sende-/Empfangseinrichtung 12 zum Senden auf den Bus 40 bereitgestellt wird. Hierbei erstellt die Kommunikationssteuereinrichtung 11 den Rahmen 450 bei dem vorliegenden Ausführungsbeispiel als kompatibel mit CAN FD, wie auch in Fig. 2 veranschaulicht. Dasselbe gilt analog für die Kommunikationssteuereinrichtung 31 und die Sende-/Empfangseinrichtung 32 der Teilnehmerstation 30.

Gemäß Fig. 2 ist der CAN XL-Rahmen 450 für die CAN-Kommunikation auf dem Bus 40 in unterschiedliche Kommunikationsphasen 451, 452 unterteilt, nämlich eine Arbitrationsphase 451 und eine Datenphase 452. Der Rahmen 450 hat ein Arbitrationsfeld 453, ein Steuerfeld 454 mit einem ADS-Feld für eine Umschaltung zwischen den Kommunikationsphasen 451, 452, ein Datenfeld 455, ein Prüfsummenfeld 456 sowie ein Rahmenabschlussfeld 457, in dem ein DAS-Feld für eine Umschaltung zwischen den Kommunikationsphasen 452, 451 vorhanden ist. Danach folgt ein Rahmenendefeld EOF.

In der Arbitrationsphase 451 wird mit Hilfe eines Identifizierers (ID) mit beispielsweise Bits ID28 bis ID18 in dem Arbitrationsfeld 453 bitweise zwischen den Teilnehmerstationen 10, 20, 30 ausgehandelt, welche Teilnehmerstation 10, 20, 30 die Nachricht 45, 46 mit der höchsten Priorität senden möchte und daher für die nächste Zeit zum Senden in der anschließenden Datenphase 452 einen exklusiven Zugriff auf den Bus 40 des Bussystems 1 bekommt. In der Arbitrationsphase 451 wird ein Physical Layer wie bei CAN und CAN-FD verwendet. Der Physical Layer entspricht der Bitübertragungsschicht oder Schicht 1 des bekannten OSI-Modells (Open Systems Interconnection Modell).

Ein wichtiger Punkt während der Phase 451 ist, dass das bekannte CSMA/CR-Verfahren Verwendung findet, welches gleichzeitigen Zugriff der Teilnehmerstationen 10, 20, 30 auf den Bus 40 erlaubt, ohne dass die höher priorisierte Nachricht 45, 46 zerstört wird. Dadurch können dem Bussystem 1 relativ einfach weitere Bus-Teilnehmerstationen 10, 20, 30 hinzugefügt werden, was sehr vorteilhaft ist.

Das CSMA/CR-Verfahren hat zur Folge, dass es sogenannte rezessive Zustände auf dem Bus 40 geben muss, welche von anderen Teilnehmerstationen 10, 20, 30 mit dominanten Zuständen auf dem Bus 40 überschrieben werden können. Im rezessiven Zustand herrschen an der einzelnen Teilnehmerstation 10, 20, 30 hochohmige Verhältnisse, was in Kombination mit den Parasiten der Busbeschaltung längere Zeitkonstanten zur Folge hat. Dies führt zu einer Begrenzung der maximalen Bitrate des heutigen CAN-FD-Physical-Layer auf derzeit etwa 2 Megabit pro Sekunde im realen Fahrzeug-Einsatz.

In der Datenphase 452 werden neben einem Teil des Steuerfelds 454 die Nutzdaten des CAN-XL-Rahmens bzw. der Nachricht 45 aus dem Datenfeld 455 sowie das Prüfsummenfeld 456 gesendet. Danach folgt das DAS-Feld, das zur Umschaltung von der Datenphase 452 zurück zur Datenphase 451 dient.

Ein Sender der Nachricht 45 beginnt ein Senden von Bits der Datenphase 452 auf den Bus 40 erst, wenn die Teilnehmerstation 10 als der Sender die Arbitration gewonnen hat und die Teilnehmerstation 10 als Sender damit zum Senden einen exklusiven Zugriff auf den Bus 40 des Bussystems 1 hat.

Ganz allgemein können in dem Bussystem mit CAN XL im Vergleich zu CAN oder CAN FD folgende abweichenden Eigenschaften realisiert werden:
a) Übernahme und ggf. Anpassung bewährter Eigenschaften, die für die Robustheit und Anwenderfreundlichkeit von CAN und CAN FD verantwortlich sind, insbesondere Rahmenstruktur mit Identifier und Arbitrierung nach dem CSMA/CR-Verfahren,
b) Steigerung der Netto-Datenübertragungsrate, insbesondere auf etwa 10 Megabit pro Sekunde,
c) Anheben der Größe der Nutzdaten pro Rahmen, insbesondere auf etwa 2kbyte oder einen beliebigen anderen Wert.

Wie in Fig. 2 dargestellt, verwendet die Teilnehmerstation 10 in der Arbitrationsphase 451 als erster Kommunikationsphase teilweise, insbesondere bis zum FDF-Bit (inklusive), ein von CAN/CAN-FD bekanntes Format gemäß der ISO11898-1:2015. Dagegen verwendet die Teilnehmerstation 10 ab dem FDF-Bit in der ersten Kommunikationsphase sowie in der zweiten Kommunikationsphase, der Datenphase 452, ein CAN XL Format, das nachfolgend beschrieben ist.

Bei dem vorliegenden Ausführungsbeispiel sind CAN XL und CAN FD kompatibel. Hierbei wird das von CAN FD bekannte res-Bit, das nachfolgend XLF-Bit genannt ist, für die Umschaltung von dem CAN FD Format zu dem CAN XL Format genutzt. Daher sind die Rahmenformate von CAN FD und CAN XL bis zum res-Bit bzw. XLF-Bit gleich. Ein Empfänger erkennt erst bei dem res-Bit, in welchem Format der Rahmen 450 gesendet wird. Eine CAN XL Teilnehmerstation, also hier die Teilnehmerstationen 10, 30, unterstützt auch CAN FD.

Alternativ zu dem in Fig. 2 gezeigten Rahmen 450, bei welchem ein Identifizierer (Identifier) ID28 bis ID18 mit 11 Bit verwendet wird, ist optional ein CAN XL Erweitertes Rahmenformat möglich, bei dem ein Identifizierer (Identifier) mit 29 Bit verwendet wird. Dies ist bis zum FDF-Bit identisch zu dem bekannten CAN FD Erweiterten Rahmenformat aus der ISO11898-1:2015.

Gemäß Fig. 2 ist der Rahmen 450 vom SOF-Bit bis einschließlich zum FDF-Bit identisch zum CAN FD Base Frame Format gemäß der ISO11898-1:2015. Daher ist der bekannte Aufbau hier nicht weiter erläutert. Bits, die an ihrer unteren Linie in Fig. 2 mit einem dicken Strich dargestellt sind, werden in dem Rahmen 450 als dominant oder ,0' gesendet. Bits, die an ihrer oberen Linie in Fig. 2 mit einem dicken Strich dargestellt sind, werden in dem Rahmen 450 als rezessiv oder '1' gesendet. In der CAN XL Datenphase 452 werden symmetrische '1' und ,0' Pegel verwendet, statt rezessiver und dominanter Pegel.

Allgemein werden bei der Erzeugung des Rahmens 450 zwei unterschiedliche Stuffing-Regeln angewendet. Bis vor dem FDF-Bit im Arbitrationsfeld 453 gilt die dynamische Bit-Stuffing-Regel von CAN FD, so dass nach 5 gleichen Bits in Folge ein inverses Stuff-Bit einzufügen ist. In der Datenphase 452 bis vor das FCP-Feld gilt eine feste Stuffing-Regel, so dass nach einer festen Zahl von Bits ein fixed Stuff-Bit einzufügen ist. Alternativ können statt nur einem Stuff-Bit eine Anzahl von 2 oder mehr Bits als fixed Stuff-Bits eingefügt werden.

In dem Rahmen 450 folgt direkt nach dem FDF-Bit das XLF-Bit, das von der Position her dem "res Bit" im CAN FD Base Frame Format entspricht, wie zuvor erwähnt. Wird das XLF-Bit als 1, also rezessiv, gesendet, identifiziert es damit den Rahmen 450 als CAN XL-Rahmen. Für einen CAN FD Rahmen setzt die Kommunikationssteuereinrichtung 11 das XLF-Bit als 0, also dominant.

Nach dem XLF-Bit folgt in dem Rahmen 450 ein resXL-Bit, das ein dominantes Bit für die zukünftige Nutzung ist. Das resXL muss für den Rahmen 450 als 0, also dominant, gesendet werden. Empfängt die Teilnehmerstation 10 jedoch ein resXL-Bit als 1, also rezessiv, geht die empfangende Teilnehmerstation 10 beispielsweise in einen Protokollausnahmezustand (Protocoll Exception State), so wie es bei einer CAN FD Nachricht 46 für ein res=1 ausgeführt wird. Alternativ könnte das resXL-Bit genau umgekehrt definiert sein, also, dass es als 1, also rezessiv, gesendet werden muss. In diesem Fall geht die empfangende Teilnehmerstation bei einem dominanten resXL-Bit in den Protokollausnahmezustand.

Nach dem resXL-Bit folgt in dem Rahmen 450 eine Sequenz ADS (Arbitration Data Switch), in welcher eine vorbestimmte Bitsequenz codiert wird. Diese Bitsequenz erlaubt eine einfache und sichere Umschaltung von der Bitrate der Arbitrationsphase 451 (Arbitrationsbitrate) zu der Bitrate der Datenphase 452 (Datenbitrate). Beispielsweise besteht die Bitsequenz der ADS-Sequenz aus einem AL1-Bit, das zumindest im letzten Teil als logische 1, gesendet wird. Das AL1-Bit ist das letzte Bit der Arbitrationsphase 451. Innerhalb des AL1-Bits wird der Physical Layer in der Sende-/Empfangseinrichtung 12, 22, 32 umgeschaltet. Somit wird während der Sequenz ADS auch die Betriebsart der Sende-Empfangseinrichtung 12, 32 umgeschaltet. Die folgenden Bits DH1, DH2 und DL1 werden bereits mit der Datenbitrate gesendet. Somit sind die Bits DH1, DH2 und DL1 bei CAN XL zeitlich kurze Bits der Datenphase 452. Das ADS-Feld wird zum Übergang von der ersten Kommunikationsphase 451 in die zweite Kommunikationsphase 452 verwendet.

Nach der Sequenz ADS folgt in dem Rahmen 450 ein SDT-Feld, das den Inhalt des Datenfeldes 455 kennzeichnet. Der Inhalt des SDT-Felds gibt an, welche Art von Information in dem Datenfeld 455 enthalten ist. Beispielsweise gibt das SDT-Feld an, ob sich im Datenfeld 455 ein "Internet Protocol" (IP) Rahmen befinden, oder ein getunnelter Ethernet Rahmen oder sonstiges.

Auf das SDT-Feld folgt ein SEC-Feld, das angibt, ob der Rahmen 450 mit dem CAN Sicherheitsprotokoll abgesichert ist oder nicht. Das SEC-Feld ist 1 Bit breit und hat wie das SDT Feld die Funktion anzugeben, welche Art von Information im Datenfeld 455 enthalten ist.

An das SEC-Feld schließt sich ein DLC-Feld an, in welchem der Datenlängencode (DLC = Data Length Code) eingefügt wird, welcher die Anzahl der Datenbytes im Datenfeld 455 des Rahmens 450 angibt. Der Datenlängencode (DLC) kann jeden Wert von 1 bis zur maximalen Zahl von Bytes des Datenfelds 455 bzw. Datenfeld-Länge annehmen. Beträgt die maximale Datenfeld-Länge insbesondere 2048 Bit, benötigt der Datenlängencode (DLC) eine Anzahl von 11 Bits unter den Annahmen, dass DLC = 0 eine Datenfeld-Länge mit einer Anzahl von 1 Byte bedeutet und DLC = 2047 eine Datenfeld-Länge mit einer Anzahl von 2048 Byte Datenfeld-Länge bedeutet. Alternativ könnte ein Datenfeld 455 der Länge 0 erlaubt sein, wie beispielsweise bei CAN. Hierbei würde DLC = 0 beispielsweise die Datenfeld-Länge mit der Anzahl von 0 Bytes codieren. Die maximale codierbare Datenfeldlänge ist mit beispielsweise 11 Bit dann (2¹¹)-1 = 2047.

Nach dem DLC-Feld folgt in dem Rahmen 450 ein SBC-Bit-Zähler-Feld (Stuff-Bit-Count). In diesem Feld ist die Anzahl der dynamischen Stuff-Bits angegeben, die im Arbitrationsfeld 453 gesendet wurden. Ein Empfangsknoten verwendet die Information des SBC-Bit-Zähler-Felds, um zu prüfen, ob der Empfangsknoten die richtige Anzahl an dynamischen Stuff-Bits empfangen hat.

Im Anschluss an das SBC-Bit-Zähler-Feld folgt eine Präambelprüfsumme PCRC, die auch Preface-CRC genannt wird. Die Präambelprüfsumme PCRC ist eine Prüfsumme zur Absicherung des Rahmenformates des Rahmens 450, das heißt aller veränderlichen Bits vom Beginn des Rahmens 450 mit dem SOF-Bit bis zum Beginn der Präambelprüfsumme PCRC, inklusive aller dynamischen und optional der fixed Stuff-Bits bis zum Beginn der Präambelprüfsumme PCRC. Die Länge der Präambelprüfsumme PCRC und damit des Prüfsummen-Polynoms gemäß der zyklischen Redundanzprüfung (CRC) ist entsprechend der gewünschten Hamming-Distanz zu wählen.

Nach der Präambelprüfsumme PCRC folgt in dem Rahmen 450 ein Feld VCID (Virtual CAN Bus ID). Das VCID-Feld hat eine Länge von 1 Byte. In dem VCID-Feld ist die Nummer eines virtuellen CAN Busses enthalten.

Nach dem Feld VCID folgt in dem Rahmen 450 ein Feld AF (Acceptance Field). Das AF-Feld hat eine Länge von 32 Bit. In dem AF-Feld ist eine Adresse oder ein anderer Wert für eine Akzeptanzfilterung enthalten.

Nach dem Feld AF folgt in dem Rahmen 450 das Datenfeld 455 (Data Field). Das Datenfeld 455 besteht aus P Bytes B, wobei P in dem DLC-Feld codiert ist, wie zuvor beschrieben. P ist eine natürliche Zahl größer oder gleich 1.

Nach dem Datenfeld 455 folgt in dem Rahmen 450 das Prüfsummenfeld 456 mit einer Rahmenprüfsumme FCRC und einem FCP-Feld. Die Rahmenprüfsumme FCRC besteht aus den Bits der Rahmenprüfsumme FCRC. Die Länge der Rahmenprüfsumme FCRC und damit des CRC Polynoms ist entsprechend der gewünschten Hamming-Distanz zu wählen. Die Rahmenprüfsumme FCRC sichert den gesamten Rahmen 450 ab. Alternativ ist optional nur das Datenfeld 455 mit der Rahmenprüfsumme FCRC abgesichert.

Nach der Rahmenprüfsumme FCRC folgt in dem Rahmen 450 das FCP-Feld, wobei FCP = Frame Check Pattern = Rahmenprüfmuster gilt. Das FCP-Feld besteht aus 4 Bit mit insbesondere der Bitfolge 1100. Ein Empfangsknoten prüft mittels des FCP-Felds, ob der Empfangsknoten bitsynchron zum Sende-Datenstrom ist. Zudem synchronisiert sich ein Empfangsknoten auf die fallende Flanke im FCP-Feld.

Nach dem FCP-Feld schließt sich das Rahmenabschlussfeld 457 an. Das Rahmenabschlussfeld 457 besteht aus zwei Feldern, nämlich dem DAS-Feld, und dem Bestätigungsfeld oder ACK-Feld mit dem mindestens einen Bit ACK und dem Bit ACK-Dlm.

Das DAS-Feld enthält die Sequenz DAS (Data Arbitration Switch), in welcher eine vorbestimmte Bitsequenz codiert wird. Die vorbestimmte Bitsequenz hat in Fig. 2 die Bits DAH, AH1, AL2. Zudem ist optional ein Bit AH2 am Ende des DAS-Felds vorgesehen, das zum Abstandhalten zu dem Bestätigungsfeld (ACK) dient. Das DAS-Feld hat mindestens drei Bits. Die Bitsequenz DAH, AH1, AL2 erlaubt eine einfache und sichere Umschaltung von der Daten-Bitrate der Datenphase 452 zu der Arbitrations-Bitrate der Arbitrationsphase 451. Zudem wird während des DAS-Felds die Betriebsart der Sende-/Empfangseinrichtung 12, 32, optional von einer Betriebsart FAST in die Betriebsart SLOW, umgeschaltet. Beispielsweise hat die Bitsequenz der Sequenz DAS ein Arbitrationsbit DAH und ein Arbitrationsbit AH1, die jeweils den logischen Wert 1 haben. Innerhalb des Bits DAH oder des Bits AH1 wird der Physical Layer also die Betriebsart der Sende-Empfangseinrichtung 12, 32 umgeschaltet von FAST_TX oder FAST _RX nach SLOW. Auf das Bit AH1 folgt das Bit AL2 (logisch 0) und das Bit AH2 (logisch 1). Die drei Bits DAH, AH1, AL2 haben die Funktion, am Ende des Rahmens die Synchronisation der Teilnehmerstationen des Bussystems sicherzustellen. Damit wird auch die Synchronisation derjenigen Empfangsknoten sichergestellt, die einen Fehler während des Empfangs erkannt haben.

In dem Rahmenabschlussfeld 457 folgt nach der Sequenz des DAS-Felds das Bestätigungsfeld (ACK). In dem Bestätigungsfeld sind Bits zur Bestätigung oder Nichtbestätigung eines korrekten Empfangs des Rahmens 450 vorgesehen. Bei dem Beispiel von Fig. 2 sind ein ACK-Bit und ein ACK-dlm-Bit vorgesehen. Optional können zusätzlich ein NACK-Bit und ein NACK-dlm-Bit vorhanden sein. Das ACK-Bit senden die empfangenden Teilnehmerstation 10, 30 als dominant, wenn sie den Rahmen 450 korrekt empfangen haben. Die sendende Teilnehmerstation sendet das ACK-Bit als rezessiv. Daher kann das ursprünglich in dem Rahmen 450 auf den Bus 40 gesendete Bit von den empfangenden Teilnehmerstationen 10, 30 überschrieben werden. Das ACK-dlm-Bit wird als ein rezessives Bit gesendet, welches zur Abtrennung zu anderen Feldern dient. Das NACK-Bit und das NACK-dlm Bit dienen dazu, dass eine empfangende Teilnehmerstation einen nicht korrekten Empfang des Rahmens 450 auf dem Bus 40 signalisieren kann. Die Funktion der Bits ist wie die des ACK-Bits und des ACK-dlm-Bits.

Nach dem Rahmenabschlussfeld 457 folgt in dem Rahmen 450 ein Endefeld (EOF = End of Frame). Die Bitsequenz des Endefelds (EOF) dient dazu, das Ende des Rahmens 450 zu kennzeichnen. Das Endefeld (EOF) sorgt dafür, dass am Ende des Rahmens 450 eine Anzahl von 8 rezessiven Bits gesendet wird. Das ist eine Bitfolge, die innerhalb des Rahmens 450 nicht auftreten kann. Dadurch kann von den Teilnehmerstationen 10, 20, 30 das Ende des Rahmens 450 sicher erkannt werden.

Das Endefeld (EOF) hat eine Länge, die abhängig davon unterschiedlich ist, ob im ACK-Bit ein dominantes Bit oder ein rezessives Bit gesehen wurde. Wenn die sendende Teilnehmerstation das ACK-Bit als dominant empfangen hat, dann hat das Endefeld (EOF) eine Anzahl von 7 rezessiven Bits. Ansonsten ist das Endefeld (EOF) nur 5 rezessive Bits lang.

Nach dem Endefeld (EOF) folgt in dem Rahmen 450 ein Zwischenrahmenabstand (IFS - Inter Frame Space), der in Fig. 2 nicht dargestellt ist. Dieser Zwischenrahmenabstand (IFS) ist ausgestaltet wie bei CAN FD entsprechend der ISO11898-1:2015.

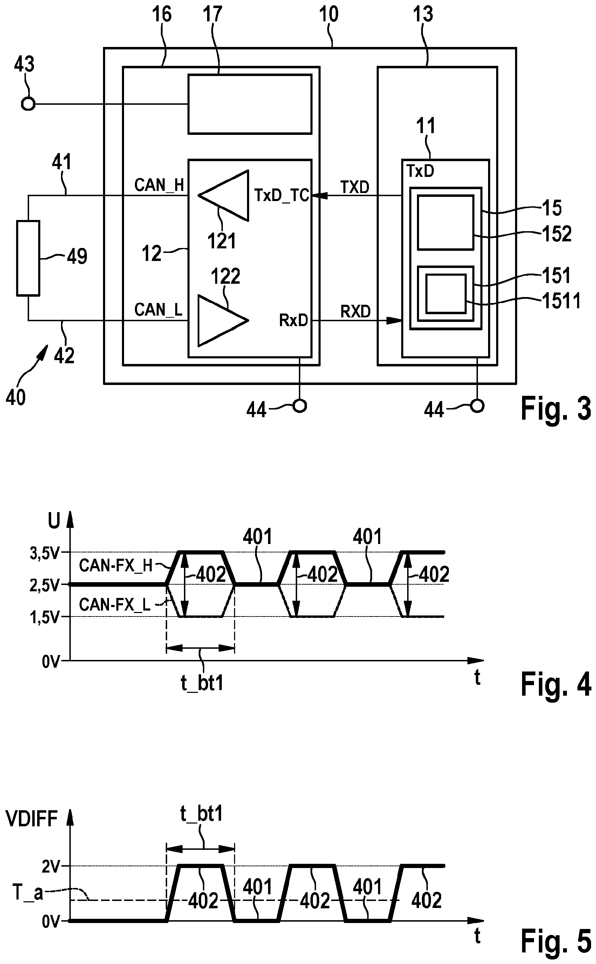

Fig. 3 zeigt den grundlegenden Aufbau der Teilnehmerstation 10 mit der Kommunikationssteuereinrichtung 11, der Sende-/Empfangseinrichtung 12 und dem Fehlerbehandlungsmodul 15, das Teil der Kommunikationssteuereinrichtung 11 ist. Die Teilnehmerstation 30 ist in ähnlicher Weise aufgebaut, wie in Fig. 3 gezeigt, jedoch ist das Fehlerbehandlungsmodul 35 gemäß Fig. 1 separat von der Kommunikationssteuereinrichtung 31 und der Sende-/Empfangseinrichtung 32 angeordnet. Daher wird die Teilnehmerstation 30 nicht separat beschrieben.

Gemäß Fig. 3 hat die Teilnehmerstation 10 zusätzlich zu der Kommunikationssteuereinrichtung 11 und der Sende-/Empfangseinrichtung 12 einen Mikrocontroller 13, welchem die Kommunikationssteuereinrichtung 11 zugeordnet ist, und eine System-ASIC 16 (ASIC = Anwendungsspezifische Integrierte Schaltung), die alternativ ein System Basis-Chip (SBC) sein kann, auf dem mehrere für eine Elektronik-Baugruppe der Teilnehmerstation 10 notwendige Funktionen zusammengefasst sind. In dem System-ASIC 16 ist zusätzlich zu der Sende-/Empfangseinrichtung 12 eine Energieversorgungseinrichtung 17 eingebaut, welche die Sende-/Empfangseinrichtung 12 mit elektrischer Energie versorgt. Die Energieversorgungseinrichtung 17 liefert üblicherweise eine Spannung CAN_Supply von 5 V. Je nach Bedarf kann die Energieversorgungseinrichtung 17 jedoch eine andere Spannung mit einem anderen Wert liefern. Zusätzlich oder alternativ kann die Energieversorgungseinrichtung 17 als Stromquelle ausgestaltet sein.

Das Fehlerbehandlungsmodul 15 hat einen Einfügeblock 151, der ein vorbestimmtes DAS-Feld 1511 in den Rahmen 450 einfügt, und einen Signalisierblock 152. Die Blöcke 151, 152 sind nachfolgend noch genauer beschrieben sind.

Die Sende-/Empfangseinrichtung 12 hat zudem ein Sendemodul 121 und ein Empfangsmodul 122. Auch wenn nachfolgend immer von der Sende-/Empfangseinrichtung 12 gesprochen ist, ist es alternativ möglich, das Empfangsmodul 122 in einer separaten Einrichtung extern von dem Sendemodul 121 vorzusehen. Das Sendemodul 121 und das Empfangsmodul 122 können wie bei einer herkömmlichen Sende-/Empfangseinrichtung 22 aufgebaut sein. Das Sendemodul 121 kann insbesondere mindestens einen Operationsverstärker und/oder einen Transistor aufweisen. Das Empfangsmodul 122 kann insbesondere mindestens einen Operationsverstärker und/oder einen Transistor aufweisen.

Die Sende-/Empfangseinrichtung 12 ist an den Bus 40 angeschlossen, genauer gesagt dessen erste Busader 41 für CAN_H oder CAN-XL_H und dessen zweite Busader 42 für CAN_L oder CAN-XL_L. Über mindestens einen Anschluss 43 erfolgt die Spannungsversorgung für die Energieversorgungseinrichtung 17 zum Versorgen der ersten und zweiten Busader 41, 42 mit elektrischer Energie, insbesondere mit der Spannung CAN-Supply. Die Verbindung mit Masse bzw. CAN_GND ist über einen Anschluss 44 realisiert. Die erste und zweite Busader 41, 42 sind mit einem Abschlusswiderstand 49 terminiert.

Die erste und zweite Busader 41, 42 sind in der Sende-/Empfangseinrichtung 12 nicht nur mit dem Sendemodul 121, das auch als Transmitter bezeichnet wird, sondern auch mit dem Empfangsmodul 122 verbunden, das auch als Receiver bezeichnet wird, auch wenn die Verbindung in Fig. 3 zur Vereinfachung nicht gezeigt ist.

Im Betrieb des Bussystems 1 setzt das Sendemodul 121 ein Sendesignal TXD oder TxD der Kommunikationssteuereinrichtung 11 in entsprechende Signale CAN-XL_H und CAN-XL_L für die Busadern 41, 42 um und sendet diese Signale CAN-XL_H und CAN-XL_L an den Anschlüssen für CAN_H und CAN_L auf den Bus 40.

Das Empfangsmodul 122 bildet aus von dem Bus 40 empfangenen Signalen CAN-XL_H und CAN-XL_L gemäß Fig. 4 ein Empfangssignal RXD oder RxD und gibt dieses an die Kommunikationssteuereinrichtung 11 weiter, wie in Fig. 3 gezeigt. Mit Ausnahme eines Leerlauf- oder Bereitschaftszustands (Idle oder Standby), hört die Sende-/Empfangseinrichtung 12 mit dem Empfangsmodul 122 im Normalbetrieb immer auf eine Übertragung von Daten bzw. Nachrichten 45, 46 auf dem Bus 40 und zwar unabhängig davon, ob die Sende-/Empfangseinrichtung 12 Sender der Nachricht 45 ist oder nicht.

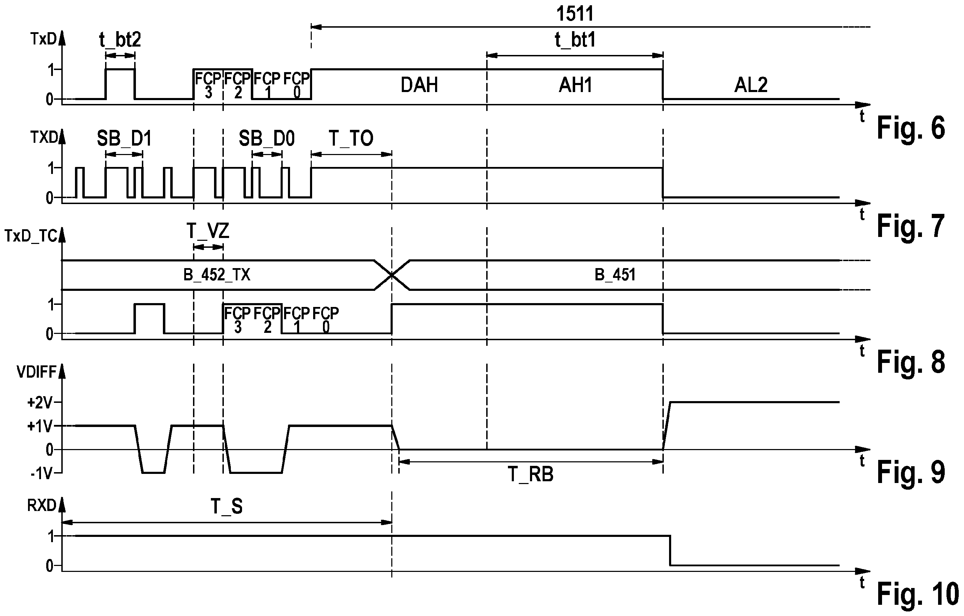

Gemäß dem Beispiel von Fig. 4 haben die Signale CAN-XL_H und CAN-XL_L zumindest in der Arbitrationsphase 451 die dominanten und rezessiven Buspegel 401, 402, wie von CAN bekannt. Auf dem Bus 40 bildet sich ein Differenzsignal VDIFF = CAN-XL_H - CAN-XL_L aus, das in Fig. 5 für die Arbitrationsphase 451 gezeigt ist. Die einzelnen Bits des Signals VDIFF mit der Bitzeit t_bt1 können in der Arbitrationsphase 451 mit einer Empfangsschwelle T_a von beispielsweise 0,7 V erkannt werden. In der Datenphase 452 werden die Bits der Signale CAN-XL_H und CAN-XL_L schneller, also mit einer kürzeren Bitzeit t_bt2, gesendet als in der Arbitrationsphase 451. Dies ist anhand von Fig. 6 bis Fig. 10 genauer beschrieben. Somit unterscheiden sich die Signale CAN-XL_H und CAN-XL_L in der Datenphase 452 zumindest in deren schnelleren Bitrate von den herkömmlichen Signalen CAN_H und CAN_L.

Die Abfolge der Zustände 401, 402 für die Signale CAN-XL_H, CAN-XL_L in Fig. 4 und der daraus resultierende Verlauf der Spannung VDIFF von Fig. 5 dient nur der Veranschaulichung der Funktion der Teilnehmerstation 10. Die Abfolge der Datenzustände für die Buszustände 401, 402 ist je nach Bedarf wählbar.

Mit anderen Worten erzeugt das Sendemodul 121, wenn es in eine erste Betriebsart B_451 (SLOW) geschaltet ist, gemäß Fig. 4 einen ersten Datenzustand als Buszustand 402 mit unterschiedlichen Buspegeln für zwei Busadern 41, 42 der Busleitung und einen zweiten Datenzustand als Buszustand 401 mit demselben Buspegel für die zwei Busadern 41, 42 der Busleitung des Busses 40.

Außerdem sendet das Sendemodul 121, für die zeitlichen Verläufe der Signale CAN-XL_H, CAN-XL_L in einer zweiten Betriebsart B_452_TX (FAST_TX), welche die Datenphase 452 umfasst, die Bits mit einer höheren Bitrate auf den Bus 40. Die CAN-XL_H und CAN-XL_L Signale können in der Datenphase 452 zudem mit einem anderen Physical Layer als bei CAN FD erzeugt werden. Dadurch kann die Bitrate in der Datenphase 452 noch weiter erhöht werden als bei CAN FD. Eine Teilnehmerstation, die in der Datenphase 452 kein Sender des Rahmens 450 ist, stellt in ihrer Sende-/Empfangseinrichtung eine dritte Betriebsart B_452_RX (FAST_RX) ein.

Zur Signalisierung der Umschaltung von der Betriebsart B_451 in die Betriebsart B_452_TX (FAST_TX) oder die Betriebsart B_452_RX (FAST_RX) führt die Kommunikationssteuereinrichtung 11 eine Pulsweitenmodulation (PWM) des Sendesignals TxD durch. Dazu verwendet die Kommunikationssteuereinrichtung 11 ein oder mehr PWM-Symbole pro logischem Bit des CAN XL Rahmens 450. Grundsätzlich gilt, dass ein PWM-Symbol aus zwei Phasen besteht, nämlich einer 0-Phase und einer 1-Phase. Außerdem wird ein PWM-Symbol von zwei gleichen Flanken begrenzt, beispielsweise von zwei steigenden Flanken.

Das Fehlerbehandlungsmodul 15 von Fig. 3, insbesondere dessen Einfügeblock 151, dient zum Einfügen des DAS-Felds 1511 in den Rahmen 450, wenn die Teilnehmerstation 10 als Sender des Rahmens 450 agiert. Zudem kann das Fehlerbehandlungsmodul 15, insbesondere sein Signalisierblock 152, die Pulsweitenmodulation (PWM) durchführen, wie nachfolgend für die Umschaltung zwischen den Betriebsarten B_452_TX (FAST_TX), B_451 (SLOW) beschrieben.

Fig. 6 zeigt über der Zeit t das resultierende digitale Sendesignal TxD im Bereich am Ende der Datenphase 452 eines Rahmens 450. In den Rahmen 450 ist nach den Bits FCP3 bis FCP0 das DAS-Feld 1511 eingefügt. Das Sendesignal TxD wird von der Kommunikationssteuereinrichtung 11 als Sender des Rahmens 450 seriell an die Sende-/Empfangseinrichtung 12 gesendet, wie nachfolgend genauer beschrieben. Bis zu dem Bit DAH haben die Bits des Rahmens 450 eine Bitdauer t_bt2. Ab dem Bit DAH haben die Bits des Rahmens 450 eine Bitdauer t_bt1. Die Bitdauer t_b2 ist bei dem Beispiel von Fig. 6 kürzer als die Bitdauer t_bt1.

Fig. 7 zeigt die über der Zeit t aus dem Sendesignal TxD resultierenden Zustände, die seriell an dem Anschluss TXD zwischen der Kommunikationssteuereinrichtung 11 und der Sende-/Empfangseinrichtung 12 auftreten. Hierfür führt die Kommunikationssteuereinrichtung 11, beispielsweise das Fehlerbehandlungsmodul 15, insbesondere der Signalisierblock 152, in der Datenphase 452 die Pulsweitenmodulation (PWM) des Sendesignals TxD von Fig. 6 durch. Bei dem Beispiel in Fig. 7 ist bei einem PWM-Symbol SB_D0 die 0-Phase länger als die 1-Phase, was einem Bit mit logischem Wert 0 in dem Sendesignal TxD entspricht. Dagegen ist bei einem PWM-Symbol SB_D1 die 1-Phase länger als die 0-Phase, was einem Bit mit logischem Wert 1 entspricht. Selbstverständlich können die PWM-Symbole SB_D0, SB_D1 anders definiert sein, insbesondere genau anders herum als zuvor beschrieben. Nach der Datenphase 452 endet die Pulsweitenmodulation (PWM) des Sendesignals TxD, wie in Fig. 6 gezeigt. In der Arbitrationsphase 451 erfolgt keine Pulsweitenmodulation (PWM) des Sendesignals TxD. Die Umschaltung von der Betriebsart B_452_TX (FAST_TX) oder der Betriebsart B_452_RX (FAST_RX) FAST_RX in die Betriebsart B_451 (SLOW) wird über das Abstellen der PWM-Codierung und somit über das Ausbleiben der vielen Flanken signalisiert.

Am Ende der Arbitrationsphase 451 erkennt die Sende-/Empfangseinrichtung 12 aufgrund der hohen Frequenz der Flanken des Sendesignals TxD, dass die Sende-/Empfangseinrichtung 12 von der Betriebsart B_451 der Arbitrationsphase in eine der schnellen Betriebsarten B_452_TX (FAST_TX), B_452_RX (FAST_RX) wechseln soll bzw. auch dort bleiben soll. Am Wert des ersten PWM-Symbols oder der M ersten Symbole erkennt die Sende-/Empfangseinrichtung 12, ob sie in die Betriebsart B_452_TX (FAST_TX) oder die Betriebsart B_452_RX (FAST_RX) wechseln soll. M ist eine natürliche Zahl die größer oder gleich 1 ist.

Fig. 8 zeigt den zeitlichen Verlauf eines Signals TxD_TC, das von der Sende-/Empfangseinrichtung 12 aus den Zuständen an dem Anschluss TXD von Fig. 7 decodiert wurde. Zudem zeigt Fig. 8 den Betriebszustand der Sende-/Empfangseinrichtung 12. Die Sende-/Empfangseinrichtung 12 schaltet ihre Betriebsart B_452_TX, in welcher der Rahmen 450 Bits mit der Bitdauer t_bt2 hat, in dem Bit DAH in die Betriebsart B_451 um, in welcher der Rahmen 450 Bits mit der Bitdauer t_bt1 hat. Zudem können die Bits des Rahmens 450 in der Betriebsart B_451 mit einem anderen Physical Layer auf den Bus 40 gesendet werden als in der Betriebsart B_452_TX, wie zuvor beschrieben. Die Sende-/Empfangseinrichtung 12 kann, insbesondere mit einem RC-Glied, nach Ablauf einer vorbestimmten Zeitdauer T_TO (TimeOut) erkennen, dass für die vorbestimmte Zeit T_TO keine Flanken angekommen sind. Erkennt die Sende-/Empfangseinrichtung 12 den Ablauf der vorbestimmten Zeitdauer T_TO (TimeOut), schaltet die Sende-/Empfangseinrichtung 12 in ihre Betriebsart B_451 (SLOW) um.

Die Sende-/Empfangseinrichtung 12 decodiert also die Zustände an dem Anschluss TXD von Fig. 7 in das Signal TxD_TC gemäß Fig. 8. Jedes der PWM-Symbole SB_D0, SB_D1 an dem Anschluss TXD kann erst an dem Ende des PWM-Symbole SB_D0, SB_D1 decodiert werden. Somit fügt die Decodierung in der Sende-/Empfangseinrichtung 12 eine Verzögerungszeitdauer T_VZ in das seriell auf den Bus 40 zu sendende Signal TxD_TC ein. Die Verzögerungszeitdauer T_VZ ist gleich der Zeitdauer einer Symbollänge eines der PWM-Symbole SB_D0, SB_D1, wie in Fig. 8 gezeigt.

Nachdem die Sende-/Empfangseinrichtung 12 die Zustände an dem Anschluss TXD von Fig. 7 in das Signal TxD_TC Sende-/Empfangseinrichtung 12 gemäß Fig. 8 decodiert hat, sendet die Sende-/Empfangseinrichtung 12 das Signal TxD_TC auf den Bus 40 als die Differenzspannung VDIFF, die in Fig. 9 gezeigt ist.

Fig. 10 zeigt über der Zeit t den Verlauf des Signals an dem RXD-Anschluss der Sende-/Empfangseinrichtung 12. Die Sende-/Empfangseinrichtung 12 sendet das Empfangssignal RxD als 1 über den RXD-Anschluss, solange die Sende-/Empfangseinrichtung 12 in der Betriebsart B_452_TX ist. Diese Zeitdauer, in welcher die Sende-/Empfangseinrichtung 12 in der Betriebsart B_452_TX ist, entspricht einer Zeitdauer T_S, deren Ende in Fig. 10 schematisch gezeigt ist. In der Betriebsart B_452_TX (FAST_TX) gilt RXD = 1. In der Betriebsart B_452 sendet die Sende-/Empfangseinrichtung 12 die Zustände über den Anschluss RXD, die den Zuständen des digitalen Empfangssignals RxD entsprechen, welches die Sende-/Empfangseinrichtung 12 aus der von dem Bus 40 empfangenen Differenzspannung VDIFF erzeugt hat.

Wie in Fig. 6 bis Fig. 10 gezeigt, ist das Fehlerbehandlungsmodul 15 von Fig. 3 somit bei dem vorliegenden Ausführungsbeispiel derart ausgestaltet, dass das DAS-Feld zwei Bits (DAH, AH1) mit dem Wert 1 gefolgt von einem Bit (AL2) mit dem Wert 0 (dominant) hat.

Das DAH-Bit ist in dem DAS-Feld 1151 ein Übergangsbit. Das DAH-Bit wird von dem Sendeknoten bzw. von der Sende-/Empfangseinrichtung 12 zumindest in dem letzten Teil mit rezessivem Pegel gesendet. Der Sendeknoten ist eine Teilnehmerstation, die in der laufenden Datenphase 452 der Sender des Rahmens 450 ist und somit den Rahmen 450 auf den Bus 40 sendet. Nachfolgend ist angenommen, dass die Teilnehmerstation 10 der Sendeknoten für den Rahmen 450 ist und die Teilnehmerstation 30 ein Empfangsknoten ist.

In der Teilnehmerstation 10 als Sendeknoten für den Rahmen 450 signalisiert die Kommunikationssteuereinrichtung 11 mit dem Anfang des DAH-Bits, dass die Sende-Empfangseinrichtung 12 ihre Betriebsart von der Betriebsart B_452_TX (FAST_TX) auf B_451 (SLOW) umzuschalten hat. Der Anfang des DAH-Bits entspricht beispielsweise bis zu 50% des DAH-Bits. Die Sende-Empfangseinrichtung 12 führt aufgrund dieser Signalisierung in dem DAH-Bit die Umschaltung ihrer Betriebsart von der Betriebsart B_452_TX (FAST_TX) auf B_451 (SLOW) nach Ablauf der vorbestimmten Zeit T_TO durch, wie in Fig. 7 und Fig. 8 gezeigt. Während der Zeitdauer T_TO ist der Buspegel gemäß Fig. 9, also der Wert von VDIFF, nicht zuverlässig rezessiv.

Gemäß Fig. 6 und Fig. 7 sendet die Teilnehmerstation 10 als Sendeknoten, genauer die Sende-/Empfangseinrichtung 12, für den Rahmen 450 das DAH-Bit im letzten Teil mit rezessivem Pegel. Der letzte Teil entspricht beispielsweise ebenfalls 50%. Danach sendet die Teilnehmerstation 10 das AH1-Bit komplett mit rezessivem Pegel. Danach sendet die Teilnehmerstation 10 das AL2-Bit komplett mit dominantem Pegel. Somit bildet sich auf dem Bus 40 für eine vorbestimmte Zeitdauer T_RB ein rezessiver Buszustand aus. Die vorbestimmte Zeitdauer T_RB entspricht bei dem Beispiel von Fig. 6 bis Fig. 9 einer Anzahl von 1,5 Bits mit der Bitdauer t_bt1.

Somit ist gemäß Fig. 6 bis Fig. 10 das FCP0-Bit das letzte Bit, das mittels PWM-Symbol codiert an die Sende-Empfangseinrichtung 12 übertragen wird. Während des DAH-Bits sendet die Kommunikationssteuereinrichtung 11, insbesondere das Fehlerbehandlungsmodul 15, das TxD Signal als 1. Weil das FCP0-Bit als Wert eine logische 0 hat, wird diese von der Einrichtung 12 als Differenzspannung mit dem Wert +1 V auf den Bus 40 getrieben. Die Sende-Empfangseinrichtung 12 erkennt nach der Zeitdauer T_TO (TimeOut) von beispielsweise 500ns oder einem anderen Wert, dass an dem Anschluss TXD keine Flanken auftreten. Daher schaltet die Sende-Empfangseinrichtung 12 ihre Betriebsart in die Betriebsart B_451 (SLOW), wie in Fig. 8 gezeigt. Da an dem TxD-Signal eine 1 anliegt, treibt die Sende-Empfangseinrichtung 12 nun einen rezessiven Pegel auf den Bus 40. Das darauffolgende AH1-Bit wird ebenfalls mit rezessivem Pegel auf den Bus 40 getrieben. Somit erzeugt der Sendeknoten unmittelbar vor dem AL2-Bit einen rezessiven Pegel mit der Dauer T_RB, der deutlich länger ist als eine Arbitrationsbitzeit t_bt1.

Im Ergebnis enthält das DAS-Feld eine Bitfolge 110, die eine sichere Synchronisationsflanke vor der Umschaltung von der Datenphase 452 in die Arbitrationsphase 451 bereitstellt. Damit kann sichergestellt werden, dass jeder Empfangsknoten, also eine Teilnehmerstation, die in der laufenden Datenphase 452 nicht der Sender des Rahmens 450 ist und daher nur Empfänger des Rahmens 450 ist, unmittelbar vor der fallenden Flanke des AL2 Bits (dominant) im DAS-Feld einen rezessiven Pegel für die Dauer t_bt1 von mindestens einem Arbitrationsbit gesehen hat. Dies gilt auch dann noch, wenn die Bits beim Empfänger verkürzt ankommen, was durch den Effekt der Bit-Asymmetrie auftreten kann. Die Bit-Asymmetrie kommt durch nicht-ideale Komponenten wie Sende-Empfangseinrichtungen 12, 22, 32 (Transceiver), Abschlusswiderstand, Stichleitungen, usw. zustande. Somit sieht jeder Empfangsknoten mindestens ein rezessives Bit vor der Flanke zwischen AH1 und AL1, was eine notwendige Vorbedingung für eine Synchronisation ist.

Damit ist eine Fehlerbehandlung möglich, bei der ein Empfangsknoten keinen Fehlerrahmen 47 sendet, sondern bei der der Empfangsknoten, wenn der Empfangsknoten einen Fehler gesehen hat, folgendermaßen vorgeht. Wird ein Fehler gesehen, schaltet der Empfangsknoten, beispielsweise die Teilnehmerstation 30, seine Sende-Empfangseinrichtung 32 in die Betriebsart der Arbitrationsphase 451 (SLOW-Betriebsart), falls die Sende-Empfangseinrichtung 32 nicht vorher schon in der Betriebsart war, und wartet auf die Bus-Idle-Sequenz bestehend aus 11 rezessiven Bits der Arbitrationsphase 451, wie zuvor beschrieben. Durch das DAS-Feld mit der Bitfolge 110 steht dann die benötigte sichere Synchronisationsflanke vor dem Beginn der Bus-Idle-Sequenz bereit.

Gemäß einer Modifikation des vorliegenden Ausführungsbeispiels signalisiert die Kommunikationssteuereinrichtung 11, beispielsweise das Fehlerbehandlungsmodul 15, insbesondere der Signalisierblock 152, der Sende-Empfangseinrichtung 12 nicht, dass die Sende-Empfangseinrichtung 12 in die Betriebsart B_452_TX (FAST_TX) zu schalten ist. Alternativ kann in der Teilnehmerstation 10 für die Kommunikationssteuereinrichtung 11 eine Sende-Empfangseinrichtung, insbesondere eine Sende-Empfangseinrichtung 22, vorhanden sein, die keine Betriebsart B_452_TX (FAST_TX) oder B_452_RX (FAST_RX) besitzt. Bei diesen beiden Alternativen sendet der Sendeknoten das DAH-Bit als ein rezessives Bit, weil es eine logische '1' ist.

Auch für diese Modifikation und deren Alternative ist sichergestellt, dass jeder Empfangsknoten unmittelbar vor der fallenden Flanke des AL2-Bits (dominant) im DAS-Feld einen rezessiven Pegel für mindestens die Dauer t_b1 gesehen hat, die die Zeitdauer eines Arbitrationsbits ist.

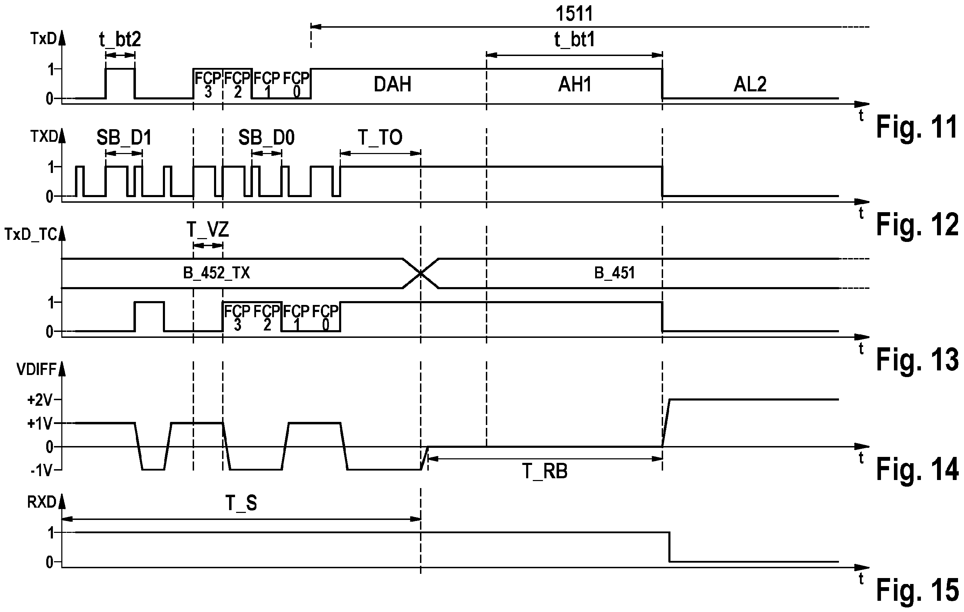

Fig. 11 bis Fig. 15 zeigen Zeitverläufe gemäß einem zweiten Ausführungsbeispiel, die sich in den nachfolgenden Aspekten von den Zeitverläufen von Fig. 6 bis Fig. 10 unterscheiden.

Wie in Fig. 12 gezeigt, wird am Anfang des DAH-Bits mindestens ein PWM-Symbol gesendet, das dem logischen Wert 1 entspricht. Bei dem Beispiel von Fig. 12 wird das PWM-Symbol SB_D1 gesendet. Hierfür führt die Kommunikationssteuereinrichtung 11, beispielsweise das Fehlerbehandlungsmodul 15, insbesondere der Signalisierblock 152, eine entsprechende Pulsweitenmodulation (PWM) des DAH-Bits durch. Anschließend sendet die Kommunikationssteuereinrichtung 11, beispielsweise das Fehlerbehandlungsmodul 15, insbesondere der Signalisierblock 152, das TxD Signal als 1 während des DAH Bits.

Weil das PWM-Symbol für die logische 1 als letztes gesendet wurde, ist das Signal TxD_TC von Fig. 13 bereits am Anfang des DAH-Bits ebenfalls logisch 1. Somit hat die Differenzspannung VDIFF für die Zeitdauer T_TO (TimeOut) (Fig. 12) des DAH-Bits einen Wert -1V, wie in Fig. 14 gezeigt.

Die Sende-Empfangseinrichtung 12 erkennt nach der Zeitdauer T_TO (TimeOut) (Fig. 12) von beispielsweise 500ns oder einem anderen Wert, dass an dem Anschluss TXD keine Flanken auftreten. Daher schaltet die Sende-Empfangseinrichtung 12 ihre Betriebsart in die Betriebsart B_451 (SLOW), wie in Fig. 13 gezeigt. Da an dem TxD-Signal eine 1 anliegt, treibt die Sende-Empfangseinrichtung 12 nun einen rezessiven Pegel auf den Bus 40. Das darauffolgende AH1-Bit wird ebenfalls mit rezessivem Pegel auf den Bus 40 getrieben.

Somit erzeugt der Sendeknoten auch bei dem vorliegenden Ausführungsbeispiel unmittelbar vor dem AL2-Bit einen rezessiven Pegel, der deutlich länger ist als eine Arbitrationsbitzeit t_bt1 .

Im Übrigen ist die Funktionsweise des Bussystems 1 der beiden Ausführungsbeispiele gleich.

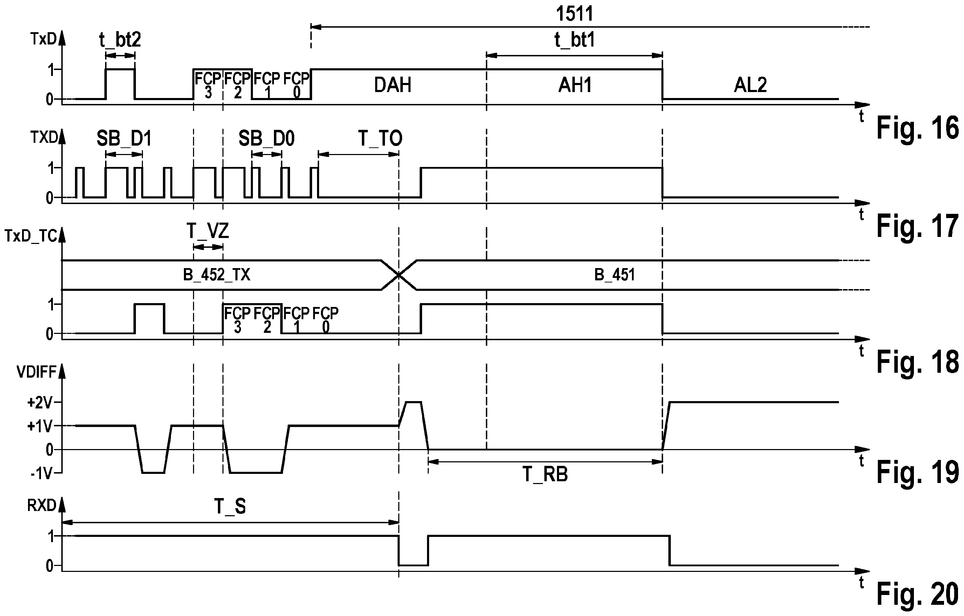

Fig. 16 bis Fig. 20 zeigen Zeitverläufe gemäß einem dritten Ausführungsbeispiel, die sich in den nachfolgenden Aspekten von den Zeitverläufen von Fig. 6 bis Fig. 10 unterscheiden.

Wie in Fig. 17 gezeigt, sendet die Kommunikationssteuereinrichtung 11, beispielsweise das Fehlerbehandlungsmodul 15, insbesondere der Signalisierblock 152, am Anfang des DAH-Bits ein PWM-Symbol, das dem logischen Wert 0 entspricht, jedoch keine abschließende Flanke hat. Hierbei wird bei dem Beispiel von Fig. 17 das PWM-Symbol SB_D0 ohne die abschließende Flanke gesendet. Anschließend sendet die Kommunikationssteuereinrichtung 11, beispielsweise das Fehlerbehandlungsmodul 15, insbesondere der Signalisierblock 152, das TxD-Signal als 0, bis die Sende-Empfangseinrichtung 12 während des DAH-Bits ihre Betriebsart in die Betriebsart B_451 (SLOW) geschaltet ist bzw. gewechselt hat, wie in Fig. 18 gezeigt.

Die Sende-Empfangseinrichtung 12 erkennt nach der Zeitdauer T_TO (TimeOut) (Fig. 17) von beispielsweise 500ns oder einem anderen Wert, dass an dem Anschluss TXD keine Flanken auftreten. Daher schaltet die Sende-Empfangseinrichtung 12 ihre Betriebsart in die Betriebsart B_451 (SLOW), wie in Fig. 18 gezeigt. Da das Signal an dem Anschluss TXD gemäß Fig. 17 zu diesem Zeitpunkt noch den Wert 0 hat, treibt die Sende-Empfangseinrichtung 12 einen dominanten Pegel auf den Bus 40. Daher hat die Differenzspannung VDIFF den Wert +2V, wie in Fig. 19 gezeigt.

Die Betriebsart B_451 (SLOW) erkennt die Kommunikationssteuereinrichtung 11, beispielsweise das Fehlerbehandlungsmodul 15, insbesondere der Signalisierblock 152, anhand des Wertes an dem RXD-Anschluss, wie in Fig. 20 gezeigt. In der Betriebsart B_452_TX (FAST_TX) gilt RXD = 1 wie durch die Zeitdauer T_S in Fig. 20 gekennzeichnet. In der Betriebsart B_451 (SLOW) ist der Wert an dem RXD-Anschluss der logische Wert der Differenzspannung VDIFF auf dem Bus 40, wie in Fig. 19 und Fig. 20 gezeigt.

Sobald die Kommunikationssteuereinrichtung 11, beispielsweise das Fehlerbehandlungsmodul 15, insbesondere der Signalisierblock 152, an dem Wert von RXD erkennt (RXD=0), dass die Sende-Empfangseinrichtung 12 in die Betriebsart B_451 (SLOW) geschaltet ist, sendet die Kommunikationssteuereinrichtung 11, beispielsweise das Fehlerbehandlungsmodul 15, insbesondere der Signalisierblock 152, das TxD Signal gemäß Fig. 16 an dem Anschluss TXD gemäß Fig. 17 für den Rest des DAH-Bits als 1. Das darauffolgende AH1-Bit wird ebenfalls mit rezessivem Pegel auf den Bus 40 getrieben.

Somit erzeugt der Sendeknoten auch bei dem vorliegenden Ausführungsbeispiel unmittelbar vor dem AL2-Bit einen rezessiven Pegel, der deutlich länger ist als eine Arbitrationsbitzeit t_bt1 .

Im Übrigen ist die Funktionsweise des Bussystems 1 gleich der der anderen Ausführungsbeispiele gleich.

Die drei Ausführungsbeispiele unterscheiden sich unter anderem darin, von welcher Differenzspannung VDIFF der Übergang zur Differenzspannung VDIFF=0 für den rezessiven Pegel erfolgt. Hierbei gibt es 3 Möglichkeiten für den Fall, dass die Betriebsartumschaltung der Sende-/Empfangseinrichtung verwendet wird, weil außer dem rezessiven Pegel der Differenzspannung VDIFF=0 noch drei weitere existieren: VDIFF=+2V für dominant, VDIFF=+1V für die logische 0 in der Datenphase und VDIFF=-1V für die logische 1 in der Datenphase 452.

Alle zuvor beschriebenen Ausgestaltungen der Teilnehmerstationen 10, 20, 30, des Bussystems 1 und des darin ausgeführten Verfahrens können einzeln oder in allen möglichen Kombinationen Verwendung finden. Insbesondere können alle Merkmale der zuvor beschriebenen Ausführungsbeispiele und/oder deren Modifikationen beliebig kombiniert werden. Zusätzlich oder alternativ sind insbesondere folgende Modifikationen denkbar.

Auch wenn die Erfindung zuvor am Beispiel des CAN-Bussystems beschrieben ist, kann die Erfindung bei jedem Kommunikationsnetzwerk und/oder Kommunikationsverfahren eingesetzt werden, bei welchem zwei verschiedene Kommunikationsphasen verwendet werden, in denen sich die Buszustände unterscheiden, die für die unterschiedlichen Kommunikationsphasen erzeugt werden. Insbesondere ist die Erfindung bei Entwicklungen von sonstigen seriellen Kommunikationsnetzwerken, wie Ethernet und/oder 100 Base-T1 Ethernet, Feldbussystemen, usw. einsetzbar.

Insbesondere kann das Bussystem 1 gemäß den Ausführungsbeispielen ein Kommunikationsnetzwerk sein, bei welchem Daten seriell mit zwei verschiedenen Bitraten übertragbar sind. Es ist vorteilhaft, jedoch nicht zwangsläufige Voraussetzung, dass bei dem Bussystem 1 zumindest für bestimmte Zeitspannen ein exklusiver, kollisionsfreier Zugriff einer Teilnehmerstation 10, 20, 30 auf einen gemeinsamen Kanal gewährleistet ist.

Selbstverständlich kann das DAS-Feld mehr als die drei Bits aufweisen die in den drei Ausführungsbeispielen beschrieben wurden. Hierbei ist nur gefordert, dass das Feld (DAS) vor der Flanke eine vorbestimmte Länge mit einer Zeitdauer T_RB hat, die länger als die Zeitdauer einer Bitzeit t_bt1 der Arbitrationsphase 451 (erste Kommunikationsphase) ist. Vorzugsweise ist die Zeitdauer T_RB gleich oder größer als die Zeitdauer von 1,5 Bits der Arbitrationsphase 451, wie zuvor beschrieben.

Die Anzahl und Anordnung der Teilnehmerstationen 10, 20, 30 in dem Bussystem 1 der Ausführungsbeispiele ist beliebig. Insbesondere kann die Teilnehmerstation 20 in dem Bussystem 1 entfallen. Es ist möglich, dass eine oder mehrere der Teilnehmerstationen 10 oder 30 in dem Bussystem 1 vorhanden sind. Denkbar ist, dass alle Teilnehmerstationen in dem Bussystem 1 gleich ausgestaltet sind, also nur Teilnehmerstation 10 oder nur Teilnehmerstation 30 vorhanden sind.

## Patentansprüche

1. Teilnehmerstation (10; 30) für ein serielles Bussystem (1), mit
einer Kommunikationssteuereinrichtung (11; 31) zum Steuern einer Kommunikation der Teilnehmerstation (10; 20; 30) mit mindestens einer anderen Teilnehmerstation (10; 20; 30) des Bussystems (1) und zur Erzeugung eines Sendesignals (TXD), so dass sich für eine Nachricht (45), die zwischen Teilnehmerstationen (10, 20, 30) des Bussystems (1) ausgetauscht wird, die Bitzeit (t_bt1) eines in einer ersten Kommunikationsphase (451) auf den Bus (40) gesendeten Signals unterscheiden kann von einer Bitzeit (t_bt2) eines in der zweiten Kommunikationsphase (452) gesendeten Signals,
wobei die Kommunikationssteuereinrichtung (11; 31) ausgestaltet ist, das Sendesignal (TxD) gemäß einem Rahmen (450) zu erzeugen und in den Rahmen (450) nach der zweiten Kommunikationsphase (452) ein Feld (DAS) mit einer Flanke einzufügen,
**dadurch gekennzeichnet, dass** das Feld (DAS) vor der Flanke eine vorbestimmte Länge entsprechend einer Zeitdauer (T_RB) hat, die länger als die Zeitdauer einer Bitzeit (t_bt1) der ersten Kommunikationsphase (451) ist, und
wobei die Flanke zur Synchronisation auf die Kommunikation auf dem Bus (40) für eine Kommunikationssteuereinrichtung (21; 31; 11) der mindestens einen anderen Teilnehmerstation (10; 20; 30) des Bussystems (1) vorgesehen ist, deren Sende-/Empfangseinrichtung (22; 32; 12) vor der vorbestimmten Zeitdauer (T_RB) in eine Betriebsart (B_451) zum Senden und Empfangen des Rahmens (450) in der ersten Kommunikationsphase (451) geschaltet ist.

2. Teilnehmerstation (10; 30) nach Anspruch 1, wobei die vorbestimmte Länge des Felds (DAS) mindestens drei Bits mit der Bitzeit (t_bt1) der ersten Kommunikationsphase (451) aufweist.

3. Teilnehmerstation (10; 30) nach Anspruch 1 oder 2, wobei die Flanke eine fallende Flanke ist.

4. Teilnehmerstation (10; 30) nach einem der vorangehenden Ansprüche, wobei die Kommunikationssteuereinrichtung (11) ausgestaltet ist, in dem Feld (DAS) vor der Flanke die Bitfolge mit dem logischen Wert 11 einzufügen.

5. Teilnehmerstation (10; 30) nach einem der vorangehenden Ansprüche, wobei die Kommunikationssteuereinrichtung (11) ausgestaltet ist, das Feld (DAS) als eine Bitfolge mit dem logischen Wert 1101 einzufügen.

6. Teilnehmerstation (10; 30) nach einem der vorangehenden Ansprüche, wobei die Kommunikationssteuereinrichtung (11) ausgestaltet ist, der Sende-/Empfangseinrichtung (12; 32) mittels Pulsweitenmodulation in dem Sendesignal (TXD) zu signalisieren, dass die Sende-/Empfangseinrichtung (12; 32) ihre Betriebsart umzuschalten hat.

7. Teilnehmerstation (10; 30) nach einem der vorangehenden Ansprüche,
zudem mit der Sende-/Empfangseinrichtung (12; 32) zum Senden des Sendesignals (TXD) auf einen Bus (40) des Bussystems (1),
wobei die Sende-/Empfangseinrichtung (12; 32) ausgestaltet ist, nach Ablauf einer vorbestimmten Zeitdauer (T_TO), in der die Sende-/Empfangseinrichtung (12; 32) in dem Sendesignal (TXD) keine Flanken empfangen hat, ihre Betriebsart von der Betriebsart (B_452_TX) der zweiten Kommunikationsphase (452) in die unterschiedliche Betriebsart (B_451) der ersten Kommunikationsphase (451) umzuschalten.

8. Teilnehmerstation (10; 30) nach Anspruch 7, wobei die Kommunikationssteuereinrichtung (11; 31) ausgestaltet ist, als letztes Symbol in dem Sendesignal (TxD, TXD) vor dem Beginn der vorbestimmten Zeitdauer (T_TO) ein PWM-Symbol (SB_D0) mit dem logischen Wert 0 einzufügen.

9. Teilnehmerstation (10; 30) nach Anspruch 7, wobei die Kommunikationssteuereinrichtung (11; 31) ausgestaltet ist, als letztes Symbol in dem Sendesignal (TxD, TXD) vor dem Beginn der vorbestimmten Zeitdauer (T_TO) ein PWM-Symbol (SB_D1) mit dem logischen Wert 1 einzufügen.

10. Teilnehmerstation (10; 30) nach Anspruch 7, wobei die Kommunikationssteuereinrichtung (11; 31) ausgestaltet ist, als vorletztes Symbol in dem Sendesignal (TxD, TXD) vor dem Beginn der vorbestimmten Zeitdauer (T_TO) ein PWM-Symbol (SB_D0) mit dem logischen Wert 0 einzufügen, und als letztes Symbol in dem Sendesignal (TxD, TXD) vor dem Beginn der vorbestimmten Zeitdauer (T_TO), ein PWM-Symbol (SB_D0) in das Sendesignal (TxD, TXD) einzufügen, das den logischen Wert 0 hat, jedoch keine abschließende Flanke hat.

11. Teilnehmerstation (10; 30) nach einem der vorangehenden Ansprüche, wobei die Kommunikationssteuereinrichtung (11; 31) ausgestaltet ist, das Signal an einem Anschluss (RXD), an welchem die Sende-/Empfangseinrichtung (12; 32) ein Empfangssignal (RxD) an die Kommunikationssteuereinrichtung (11; 31) sendet, in Bezug darauf zu prüfen, ob die Sende-/Empfangseinrichtung (12; 32) ihre Betriebsart von der Betriebsart (B_452_TX) der zweiten Kommunikationsphase (452) in die unterschiedliche Betriebsart (B_451) der ersten Kommunikationsphase (451) umgeschaltet hat.

12. Teilnehmerstation (10; 30) nach einem der Ansprüche 1 bis 4,
zudem mit der Sende-/Empfangseinrichtung (22) zum Senden des Sendesignals (TXD) auf einen Bus (40) des Bussystems (1),
wobei die Sende-/Empfangseinrichtung (22) ausgestaltet ist, den gesamten Rahmen (450) in der Betriebsart (B_452_TX) zum Senden und Empfangen des Rahmens (450) in der ersten Kommunikationsphase (451) auf den Bus (40) zu senden.

13. Teilnehmerstation (10; 30) nach einem der vorangehenden Ansprüche,
wobei der für die Nachricht (45) gebildete Rahmen (450) kompatibel zu CAN FD aufgebaut ist, und
wobei in der ersten Kommunikationsphase (451) ausgehandelt wird, welche der Teilnehmerstationen (10, 20, 30) des Bussystems (1) in der nachfolgenden zweiten Kommunikationsphase (452) einen zumindest zeitweise exklusiven, kollisionsfreien Zugriff auf den Bus (40) bekommt.

14. Bussystem (1), mit
einem Bus (40), und
mindestens zwei Teilnehmerstationen (10; 20; 30), welche über den Bus (40) derart miteinander verbunden sind, dass sie seriell miteinander kommunizieren können und von denen mindestens eine Teilnehmerstation (10; 30) eine Teilnehmerstation (10; 30) nach einem der vorangehenden Ansprüche ist.

15. Verfahren zur Kommunikation in einem seriellen Bussystem (1), wobei das Verfahren mit einer Teilnehmerstation (10; 30) des Bussystems (1) ausgeführt wird, die eine Kommunikationssteuereinrichtung (11; 31) und eine Sende-/Empfangseinrichtung (12; 22; 32) aufweist, wobei das Verfahren die Schritte aufweist,
Steuern, mit der Kommunikationssteuereinrichtung (11; 31), einer Kommunikation der Teilnehmerstation (10; 30) mit mindestens einer anderen Teilnehmerstation (10; 20; 30) des Bussystems (1), so dass sich für eine Nachricht (45), die zwischen Teilnehmerstationen (10, 20, 30) des Bussystems (1) ausgetauscht wird, die Bitzeit (t_bt1) eines in einer ersten Kommunikationsphase (451) auf den Bus (40) gesendeten Signals unterscheiden kann von einer Bitzeit (t_bt2) eines in der zweiten Kommunikationsphase (452) gesendeten Signals, und
Senden, mit der Sende-/Empfangseinrichtung (12; 32), des Sendesignals (TXD) auf einen Bus (40) des Bussystems (1),
wobei die Kommunikationssteuereinrichtung (11; 31) das Sendesignal (TxD) gemäß einem Rahmen (450) erzeugt und in den Rahmen (450) nach der zweiten Kommunikationsphase (452) ein Feld (DAS) mit einer Flanke einfügt,
**dadurch gekennzeichnet, dass** das Feld (DAS) vor der Flanke eine vorbestimmte Länge entsprechend einer Zeitdauer (T_RB) hat, die länger als die Zeitdauer einer Bitzeit (t_bt1) der ersten Kommunikationsphase (451) ist, und
wobei die Flanke zur Synchronisation auf die Kommunikation auf dem Bus (40) für eine Kommunikationssteuereinrichtung (21; 31; 11) der mindestens einen anderen Teilnehmerstation (10; 20; 30) des Bussystems (1) vorgesehen ist, deren Sende-/Empfangseinrichtung (22; 32; 12) vor der vorbestimmten Zeitdauer (T_RB) in eine Betriebsart (B_451) zum Senden und Empfangen des Rahmens (450) in der ersten Kommunikationsphase (451) geschaltet ist.

## Claims

1. Subscriber station (10; 30) for a serial bus system (1), having
a communication control device (11; 31) for controlling a communication of the subscriber station (10; 20; 30) with at least one other subscriber station (10; 20; 30) of the bus system (1) and for generating a transmission signal (TXD) such that, for a message (45) exchanged between subscriber stations (10, 20, 30) of the bus system (1), the bit time (t_bt1) of a signal transmitted to the bus (40) in a first communication phase (451) may differ from a bit time (t_bt2) of a signal transmitted in the second communication phase (452),
the communication control device (11; 31) being designed to generate the transmission signal (TxD) according to a frame (450) and to insert a field (DAS) containing an edge into the frame (450) after the second communication phase (452),
**characterized in that** the field (DAS) has a predetermined length before the edge, corresponding to a period of time (T_RB) longer than the duration of a bit time (t_bt1) of the first communication phase (451), and
wherein the edge is provided for synchronization to the communication on the bus (40) for a communication control device (21; 31; 11) of the at least one other subscriber station (10; 20; 30) of the bus system (1), the transmitting/receiving device (22; 32; 12) of said other subscriber station having been switched, before the predetermined period of time (T_RB), to a mode (B_451) for transmitting and receiving the frame (450) in the first communication phase (451).

2. Subscriber station (10; 30) according to Claim 1, wherein the predetermined length of the field (DAS) comprises at least three bits having the bit time (t_bt1) of the first communication phase (451).

3. Subscriber station (10; 30) according to Claim 1 or 2, wherein the edge is a falling edge.

4. Subscriber station (10; 30) according to one of the preceding claims, wherein the communication control device (11) is designed to insert the bit sequence containing the logic value 11 in the field (DAS) before the edge.

5. Subscriber station (10; 30) according to one of the preceding claims, wherein the communication control device (11) is designed to insert the field (DAS) as a bit sequence containing the logic value 1101.

6. Subscriber station (10; 30) according to one of the preceding claims, wherein the communication control device (11) is designed to signal to the transmitting/receiving device (12; 32), by means of pulse width modulation in the transmission signal (TXD), that the transmitting/receiving device (12; 32) needs to change over its mode.

7. Subscriber station (10; 30) according to one of the preceding claims,
moreover having the transmitting/receiving device (12; 32) for transmitting the transmission signal (TXD) to a bus (40) of the bus system (1),
wherein the transmitting/receiving device (12; 32) is designed to change over its mode from the mode (B_452_TX) of the second communication phase (452) to the different mode (B_451) of the first communication phase (451) after a predetermined period of time (T_TO) has elapsed in which the transmitting/receiving device (12; 32) received no edges in the transmission signal (TXD).

8. Subscriber station (10; 30) according to Claim 7, wherein the communication control device (11; 31) is designed to insert a PWM symbol (SB_D0) containing the logic value 0 as the last symbol in the transmission signal (TxD, TXD) before the start of the predetermined period of time (T_TO).

9. Subscriber station (10; 30) according to Claim 7, wherein the communication control device (11; 31) is designed to insert a PWM symbol (SB_D1) containing the logic value 1 as the last symbol in the transmission signal (TxD, TXD) before the start of the predetermined period of time (T_TO).

10. Subscriber station (10; 30) according to Claim 7, wherein the communication control device (11; 31) is designed to insert a PWM symbol (SB_D0) containing the logic value 0 as the penultimate symbol in the transmission signal (TxD, TXD) before the start of the predetermined period of time (T_TO), and to insert a PWM symbol (SB_D0) that has the logic value 0 but no final edge into the transmission signal (TxD, TXD) as the last symbol in the transmission signal (TxD, TXD) before the start of the predetermined period of time (T_TO).

11. Subscriber station (10; 30) according to one of the preceding claims, wherein the communication control device (11; 31) is designed to check the signal on a connection (RXD), on which the transmitting/receiving device (12; 32) transmits a received signal (RxD) to the communication control device (11; 31), for whether the transmitting/receiving device (12; 32) has changed over its mode from the mode (B_452_TX) of the second communication phase (452) to the different mode (B_451) of the first communication phase (451).

12. Subscriber station (10; 30) according to one of Claims 1 to 4,
moreover having the transmitting/receiving device (22) for transmitting the transmission signal (TXD) to a bus (40) of the bus system (1),
wherein the transmitting/receiving device (22) is designed to transmit the whole frame (450) to the bus (40) in the mode (B_452_TX) for transmitting and receiving the frame (450) in the first communication phase (451).

13. Subscriber station (10; 30) according to one of the preceding claims,
wherein the frame (450) formed for the message (45) is of compatible design with CAN FD, and
wherein the first communication phase (451) is used to negotiate which of the subscriber stations (10, 20, 30) of the bus system (1) receives at least temporarily exclusive, collision-free access to the bus (40) in the subsequent, second communication phase (452).

14. Bus system (1), having
a bus (40), and
at least two subscriber stations (10; 20; 30), which are connected to one another via the bus (40) in such a way that they can communicate serially with one another and at least one subscriber station (10; 30) of which is a subscriber station (10; 30) according to one of the preceding claims.

15. Method for communicating in a serial bus system (1), wherein the method is carried out using a subscriber station (10; 30) of the bus system (1), which subscriber station has a communication control device (11; 31) and a transmitting/receiving device (12; 22; 32), wherein the method has the steps of
using the communication control device (11; 31) to control a communication of the subscriber station (10; 30) with at least one other subscriber station (10; 20; 30) of the bus system (1) such that, for a message (45) exchanged between subscriber stations (10, 20, 30) of the bus system (1), the bit time (t_bt1) of a signal transmitted to the bus (40) in a first communication phase (451) may differ from a bit time (t_bt2) of a signal transmitted in the second communication phase (452), and using the transmitting/receiving device (12; 32) to transmit the transmission signal (TXD) to a bus (40) of the bus system (1),
the communication control device (11; 31) generating the transmission signal (TxD) according to a frame (450) and inserting a field (DAS) containing an edge into the frame (450) after the second communication phase (452),
**characterized in that** the field (DAS) has a predetermined length before the edge, corresponding to a period of time (T_RB) longer than the duration of a bit time (t_bt1) of the first communication phase (451), and
wherein the edge is provided for synchronization to the communication on the bus (40) for a communication control device (21; 31; 11) of the at least one other subscriber station (10; 20; 30) of the bus system (1), the transmitting/receiving device (22; 32; 12) of said other subscriber station having been switched, before the predetermined period of time (T_RB), to a mode (B_451) for transmitting and receiving the frame (450) in the first communication phase (451).

## Revendications

1. Station d'abonné (10 ; 30) pour un système de bus série (1), comprenant un dispositif de commande de communication (11 ; 31) permettant de commander une communication de la station d'abonné (10 ; 20 ; 30) avec au moins une autre station d'abonné (10 ; 20 ; 30) du système de bus (1) et de générer un signal d'émission (TXD), de telle sorte que, pour un message (45) qui est échangé entre des stations d'abonnés (10, 20, 30) du système de bus (1), le temps de bit (t_bt1) d'un signal émis sur le bus (40) dans une première phase de communication (451) puisse différer d'un temps de bit (t_bt2) d'un signal émis dans la seconde phase de communication (452),
dans laquelle le dispositif de commande de communication (11 ; 31) est conçu pour générer le signal d'émission (TxD) en fonction d'une trame (450) et pour introduire dans la trame (450) un champ (DAS) présentant un front après la seconde phase de communication (452),
**caractérisé en ce que** le champ (DAS) présente avant le front une longueur prédéterminée correspondant à une durée (T_RB) qui est plus longue que la durée d'un temps de bit (t_bt1) de la première phase de communication (451), et
dans laquelle le front permet une synchronisation avec la communication sur le bus (40) d'un dispositif de commande de communication (21 ; 31 ; 11) de l'au moins une autre station d'abonné (10 ; 20 ; 30) du système de bus (1), dont le dispositif d'émission/réception (22 ; 32 ; 12) est commuté avant la durée prédéterminée (T_RB) dans un mode de fonctionnement (B_451) permettant l'émission et la réception de la trame (450) dans la première phase de communication (451).

2. Station d'abonné (10 ; 30) selon la revendication 1, dans laquelle la longueur prédéterminée du champ (DAS) comprend au moins trois bits présentant le temps de bit (t_bt1) de la première phase de communication (451).

3. Station d'abonné (10 ; 30) selon la revendication 1 ou 2, dans laquelle le front est un front descendant.

4. Station d'abonné (10 ; 30) selon l'une des revendications précédentes, dans laquelle le dispositif de commande de communication (11) est conçu pour introduire la séquence de bits présentant la valeur logique 11 dans le champ (DAS) précédant le front.

5. Station d'abonné (10 ; 30) selon l'une des revendications précédentes, dans laquelle le dispositif de commande de communication (11) est conçu pour introduire le champ (DAS) sous la forme d'une séquence de bits présentant la valeur logique 1101.

6. Station d'abonné (10 ; 30) selon l'une des revendications précédentes, dans laquelle le dispositif de commande de communication (11) est conçu pour signaler au dispositif d'émission/réception (12 ; 32), au moyen d'une modulation de largeur d'impulsion dans le signal d'émission (TXD), que le dispositif d'émission/réception (12 ; 32) a commuté son mode de fonctionnement.

7. Station d'abonné (10 ; 30) selon l'une des revendications précédentes,
comprenant en outre le dispositif d'émission/réception (12 ; 32) permettant l'émission du signal d'émission (TXD) sur un bus (40) du système de bus (1),
dans laquelle le dispositif d'émission/réception (12 ; 32) est conçu pour commuter son mode de fonctionnement du mode de fonctionnement (B_452_TX) de la seconde phase de communication (452) au mode de fonctionnement différent (B_451) de la première phase de communication (451) après l'écoulement d'une durée prédéterminée (T_TO) pendant laquelle le dispositif d'émission/réception (12 ; 32) n'a pas reçu de fronts dans le signal d'émission (TXD).

8. Station d'abonné (10 ; 30) selon la revendication 7, dans laquelle le dispositif de commande de communication (11 ; 31) est conçu pour introduire, en tant que dernier symbole dans le signal d'émission (TxD, TXD) avant le début de la durée prédéterminée (T_TO), un symbole PWM (SB DO) présentant la valeur logique 0.

9. Station d'abonné (10 ; 30) selon la revendication 7, dans laquelle le dispositif de commande de communication (11 ; 31) est conçu pour introduire, en tant que dernier symbole dans le signal d'émission (TxD, TXD) avant le début de la durée prédéterminée (T_TO), un symbole PWM (SB_D1) présentant la valeur logique 1.

10. Station d'abonné (10 ; 30) selon la revendication 7, dans laquelle le dispositif de commande de communication (11 ; 31) est conçu pour introduire, en tant qu'avant-dernier symbole dans le signal d'émission (TxD, TXD) avant le début de la durée prédéterminée (T_TO), un symbole PWM (SB_D0) présentant la valeur logique 0, et pour introduire, en tant que dernier symbole dans le signal d'émission (TxD, TXD) avant le début de la durée prédéterminée (T_TO), un symbole PWM (SB_D0) dans le signal d'émission (TxD, TXD), qui présente une valeur logique de 0, mais ne présente pas de front de fermeture.

11. Station d'abonné (10 ; 30) selon l'une des revendications précédentes, dans laquelle le dispositif de commande de communication (11 ; 31) est conçu pour vérifier le signal sur une connexion (RXD) sur laquelle le dispositif d'émission/réception (12 ; 32) émet un signal de réception (RxD) au dispositif de commande de communication (11 ; 31), pour savoir si le dispositif d'émission/réception (12 ; 32) a commuté son mode de fonctionnement du mode de fonctionnement (B_452_TX) de la seconde phase de communication (452) au mode de fonctionnement différent (B_451) de la première phase de communication (451).

12. Station d'abonné (10 ; 30) selon l'une des revendications 1 à 4,
comprenant en outre le dispositif d'émission/réception (22) permettant l'émission du signal d'émission (TXD) sur un bus (40) du système de bus (1),
dans laquelle le dispositif d'émission/réception (22) est conçu pour émettre la trame entière (450) sur le bus (40) dans le mode de fonctionnement (B_452_TX) permettant l'émission et la réception de la trame (450) dans la première phase de communication (451).

13. Station d'abonné (10 ; 30) selon l'une des revendications précédentes,
dans laquelle la trame (450) formée pour le message (45) est construite de manière compatible avec CAN FD, et
dans laquelle, dans la première phase de communication (451), un traitement est effectué pour déterminer laquelle des stations d'abonnés (10, 20, 30) du système de bus (1) obtient, dans la seconde phase de communication (452) suivante, un accès au moins temporairement exclusif et sans collision au bus (40).

14. Système de bus (1), comprenant
un bus (40), et
au moins deux stations d'abonnés (10 ; 20 ; 30) qui sont reliées les unes aux autres par l'intermédiaire du bus (40) de telle sorte qu'elles puissent communiquer les unes avec les autres en série et dont au moins une station d'abonné (10 ; 30) est une station d'abonné (10 ; 30) selon l'une des revendications précédentes.

15. Procédé de communication dans un système de bus série (1), le procédé étant mis en œuvre au moyen d'une station d'abonné (10 ; 30) du système de bus (1), qui comprend un dispositif de commande de communication (11 ; 31) et un dispositif d'émission/réception (12 ; 22 ; 32), le procédé comprenant les étapes consistant à commander, au moyen du dispositif de commande de communication (11 ; 31), une communication de la station d'abonné (10 ; 30) avec au moins une autre station d'abonné (10 ; 20 ; 30) du système de bus (1), de telle sorte que, pour un message (45) qui est échangé entre des stations d'abonnés (10, 20, 30) du système de bus (1), le temps de bit (t_bt1) d'un signal émis sur le bus (40) dans une première phase de communication (451) puisse différer d'un temps de bit (t_bt2) d'un signal émis dans la seconde phase de communication (452), et
émettre, au moyen du dispositif d'émission/réception (12 ; 32), le signal d'émission (TxD) sur un bus (40) du système de bus (1),
dans lequel le dispositif de commande de communication (11 ; 31) génère le signal d'émission (TxD) en fonction d'une trame (450) et introduit dans la trame (450) un champ (DAS) présentant un front après la seconde phase de communication (452),
**caractérisé en ce que** le champ (DAS) présente avant le front une longueur prédéterminée correspondant à une durée (T_RB) qui est plus longue que la durée d'un temps de bit (t_bt1) de la première phase de communication (451), et
dans lequel le front permet une synchronisation avec la communication sur le bus (40) d'un dispositif de commande de communication (21 ; 31 ; 11) de l'au moins une autre station d'abonné (10 ; 20 ; 30) du système de bus (1), dont le dispositif d'émission/réception (22 ; 32 ; 12) est commuté avant la durée prédéterminée (T_RB) dans un mode de fonctionnement (B_451) permettant l'émission et la réception de la trame (450) dans la première phase de communication (451).
